(19)

Europäisches Patentamt

European Patent Office

Office européen des brevets

(11) **EP 4 220 244 A1**

(12) **EUROPEAN PATENT APPLICATION**
published in accordance with Art. 153(4) EPC

(43) Date of publication:
**02.08.2023 Bulletin 2023/31**

(21) Application number: **21872131.4**

(22) Date of filing: **03.09.2021**

(51) International Patent Classification (IPC):
**G02B 1/115** (2015.01)    **G02B 5/22** (2006.01)

(52) Cooperative Patent Classification (CPC):
**G02B 1/115; G02B 5/22**

(86) International application number:
**PCT/JP2021/032470**

(87) International publication number:
**WO 2022/065000 (31.03.2022 Gazette 2022/13)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **23.09.2020  JP 2020159050**

(71) Applicant: **AGC INC.**
**Chiyoda-ku,**
**Tokyo 1008405 (JP)**

(72) Inventors:
• **YASUI, Yoji**
**Tokyo 100-8405 (JP)**

• **MAESHIGE, Kazunobu**
**Tokyo 100-8405 (JP)**
• **MASHIMO, Takahiro**
**Tokyo 100-8405 (JP)**
• **OYAMA, Takuji**
**Tokyo 100-8405 (JP)**
• **AOMINE, Nobutaka**
**Tokyo 100-8405 (JP)**
• **NAGASHIMA, Tatsuo**
**Tokyo 100-8405 (JP)**
• **KOBAYASHI, Mitsuyoshi**
**Tokyo 100-8405 (JP)**

(74) Representative: **Müller-Boré & Partner**
**Patentanwälte PartG mbB**
**Friedenheimer Brücke 21**
**80639 München (DE)**

(54) **FAR-INFRARED RAY TRANSMITTING MEMBER AND METHOD FOR MANUFACTURING FAR-INFRARED RAY TRANSMITTING MEMBER**

(57)    To appropriately transmit far-infrared rays while ensuring design. A far-infrared ray transmission member (20) includes a base material (30) configured to transmit far-infrared rays, and a functional film (31) formed on the base material (30). Dispersion of reflectances with respect to pieces of light at a wavelength of 360 nm to 830 nm in increments of 1 nm is equal to or smaller than 30, a reflectance with respect to visible light defined by JIS R3106 is equal to or lower than 25%, and an average transmittance with respect to light at a wavelength of 8 um to 12 um is equal to or higher than 50%.

FIG.5

EP 4 220 244 A1

**Description**

Field

The present invention relates to a far-infrared ray transmission member and a method for manufacturing the far-infrared ray transmission member.

Background

For example, in attaching a far-infrared sensor to a vehicle and the like, a far-infrared ray transmission member may be disposed so that far-infrared rays are appropriately incident on the far-infrared sensor in some cases, the far-infrared ray transmission member on which an antireflection film is formed for suppressing reflection of far-infrared rays to increase an amount of transmitted light. For example, Patent Literature 1 describes a case of using, for a vehicle-mounted imaging device, an infrared-ray transmission film having an extinction coefficient in a far-infrared region equal to or smaller than 0.4. Non Patent Literatures 1 and 2 describe a case of forming an NiO film as an antireflection film for infrared rays on an Si substrate.

Citation List

Patent Literature

Patent Literature 1: Japanese Patent Application Laid-open No. 2017-151408

Non Patent Literature

Non Patent Literature 1: Hyun Bin Shim et al., Controlling the infrared optical properties of rf-sputtered NiO films for application of infrared window, Infrared Physics and Technology 72 (2015), 135-139
Non Patent Literature 2: Hyun Bin Shim et al., Nickel oxide film as an AR coating of Si window for IRsensor packaging, Infrared Technology and Applications XXXIX, Proc.of SPIE Vol, 8704 870420-1

Summary

Technical Problem

Such a far-infrared ray transmission member is preferably inconspicuous in view of design in a case of being disposed to be exposed to the outside, for example. Accordingly, there is a demand for a far-infrared ray transmission member that appropriately transmits far-infrared rays while ensuring design.

The present invention aims at providing a far-infrared ray transmission member that appropriately transmits far-infrared rays while ensuring design, and a method for manufacturing the far-infrared ray transmission member.

Solution to Problem

To solve the problem above, a far-infrared ray transmission member of the present disclosure comprises: a base material configured to transmit far-infrared rays; and a functional film formed on the base material, wherein dispersion of reflectances with respect to pieces of light at a wavelength of 360 nm to 830 nm in increments of 1 nm is equal to or smaller than 30, a reflectance with respect to visible light defined by JIS R3106 is equal to or lower than 25%, and an average transmittance with respect to light at a wavelength of 8 um to 12 um is equal to or higher than 50%.

To solve the problem above, a method for manufacturing a far-infrared ray transmission member, the method comprises: forming a functional film on a base material configured to transmit far-infrared rays to manufacture the far-infrared ray transmission member in which dispersion of reflectances with respect to pieces of light at a wavelength of 360 nm to 830 nm in increments of 1 nm is equal to or smaller than 30, a reflectance with respect to visible light defined by JIS R3106 is equal to or lower than 25%, and an average transmittance with respect to light at a wavelength of 8 um to 12 um is equal to or higher than 50%.

Advantageous Effects of Invention

According to the present invention, far-infrared rays can be appropriately transmitted, and design can be ensured.

Brief Description of Drawings

FIG. 1 is a schematic diagram illustrating a state in which glass for vehicles according to the present embodiment is mounted on a vehicle.
FIG. 2 is a schematic plan view of glass 1 for vehicles according to a first embodiment.
FIG. 3 is a cross-sectional view along a line A-A in FIG. 2.
FIG. 4 is a cross-sectional view along a B-B cross section in FIG. 2.
FIG. 5 is a schematic cross-sectional view of a far-infrared ray transmission member according to the present embodiment.
FIG. 6 is a schematic cross-sectional view of a far-infrared ray transmission member according to another example of the present embodiment.
FIG. 7 is a schematic cross-sectional view of a far-infrared ray transmission member according to another example of the present embodiment.
FIG. 8 is a graph illustrating evaluation results of respective examples.
FIG. 9 is a graph illustrating evaluation results of respective examples.

Description of Embodiments

The following describes a preferred embodiment of the present invention in detail with reference to the attached drawings. The present invention is not limited to this embodiment, and in a case in which there are a plurality of embodiments, the present invention encompasses a combination of the embodiments. Numerical values encompass rounded numerical values.

(Vehicle)

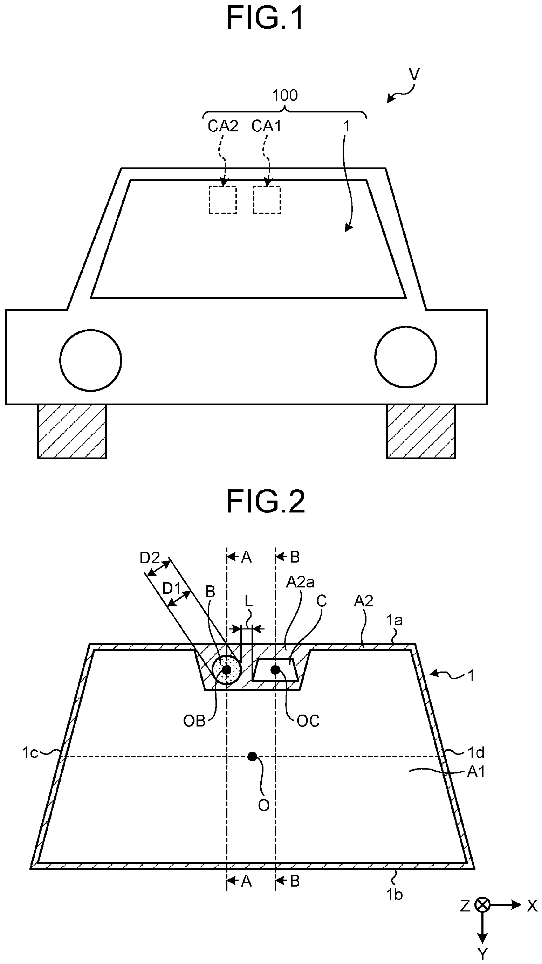

FIG. 1 is a schematic diagram illustrating a state in which glass for vehicles according to the present embodiment is mounted on a vehicle. As illustrated in FIG. 1, the glass 1 for vehicles according to the present embodiment is mounted on a vehicle V. The glass 1 for vehicles is a window member applied to a windshield of the vehicle V. That is, the glass 1 for vehicles is used as a front window of the vehicle V, in other words, as wind shield glass. A far-infrared camera CA1 and a visible light camera CA2 are mounted in an inner part (inside) of the vehicle V. The inner part (inside) of the vehicle V indicates the inside of a compartment in which a driver's seat for a driver is disposed, for example.
The glass 1 for vehicles, the far-infrared camera CA1, and the visible light camera CA2 configure a camera unit 100 according to the present embodiment. The far-infrared camera CA1 is a camera that detects far-infrared rays, and takes a thermal image of the outside of the vehicle V by detecting far-infrared rays from the outside of the vehicle V. The visible light camera CA2 is a camera that detects visible light, and takes an image of the outside of the vehicle V by detecting visible light from the outside of the vehicle V. The camera unit 100 may further include a LiDAR or a millimetric wave radar, for example, in addition to the far-infrared camera CA1 and the visible light camera CA2. Herein, far-infrared rays are electromagnetic waves having a wavelength in a wavelength range from 8 um to 13 $\mu$m, for example, and visible light is electromagnetic waves having a wavelength in a wavelength range from 360 nm to 830 nm, for example. Herein, "8 um to 13 $\mu$m" and "360 nm to 830 nm" respectively indicate "equal to or larger than 8 um and equal to or smaller than 13 $\mu$m" and "equal to or larger than 360 nm and equal to or smaller than 830 nm". The same applies to the following description. The far-infrared rays may be electromagnetic waves having a wavelength in a wavelength range from 8 um to 12 $\mu$m.

(Glass for vehicles)

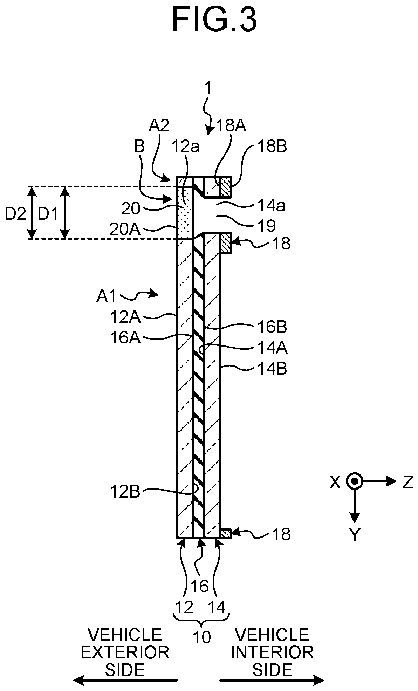

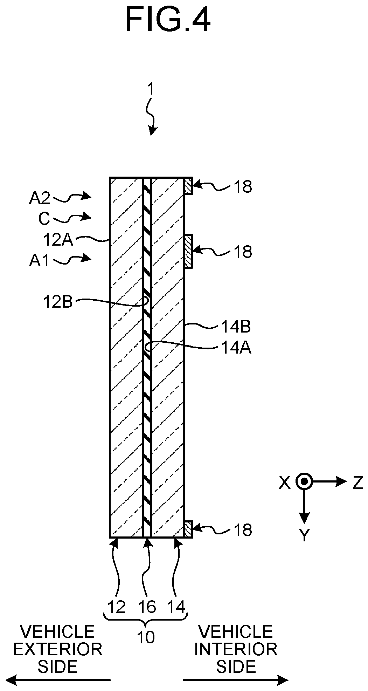

FIG. 2 is a schematic plan view of the glass 1 for vehicles according to a first embodiment. FIG. 3 is a cross-sectional view along a line A-A in FIG. 2. FIG. 4 is a cross-sectional view along a B-B cross section in FIG. 2. As illustrated in FIG. 2, an upper edge of the glass 1 for vehicles is assumed to be an upper edge part 1a, a lower edge thereof is assumed to be a lower edge part 1b, one of side edges is assumed to be a side edge part 1c, and the other one of the side edges is assumed to be a side edge part 1d hereinafter. The upper edge part 1a is an edge portion positioned on an upper side in a vertical direction when the glass 1 for vehicles is mounted on the vehicle V. The lower edge part 1b is an edge portion positioned on a lower side in the vertical direction when the glass 1 for vehicles is mounted on the vehicle V. The side edge part 1c is an edge portion positioned on one of lateral sides when the glass 1 for vehicles is mounted on the vehicle V. The side edge part 1d is an edge portion positioned on the other one of the lateral sides when the glass 1 for vehicles is mounted on the vehicle V.

Hereinafter, among directions parallel to a surface of the glass 1 for vehicles, a direction from the upper edge part 1a toward the lower edge part 1b is assumed to be a Y-direction, and a direction from the side edge part 1c toward the side edge part 1d is assumed to be an X-direction. In the present embodiment, the X-direction is orthogonal to the Y-direction. A direction orthogonal to the surface of the glass 1 for vehicles, that is, a thickness direction of the glass 1 for vehicles is assumed to be a Z-direction. The Z-direction is, for example, a direction from a vehicle exterior side toward a vehicle interior side of the vehicle V when the glass 1 for vehicles is mounted on the vehicle V. The X-direction and the Y-direction extend along the surface of the glass 1 for vehicles. For example, in a case in which the surface of the glass 1 for vehicles is a curved surface, the X-direction and the Y-direction may be directions tangent to the surface of the glass 1 for vehicles at a center point O of the glass 1 for vehicles. The center point O is a center position of the glass 1 for vehicles in a case of viewing the glass 1 for vehicles from the Z-direction.

A transparent region A1 and a light blocking region A2 are formed on the glass 1 for vehicles. The transparent region A1 is a region occupying a center portion of the glass 1 for vehicles when viewed from the Z-direction. The transparent region A1 is a region for securing a visual field of the driver. The transparent region A1 is a region for transmitting visible light. The light blocking region A2 is a region formed around the transparent region A1 when viewed from the Z-direction. The light blocking region A2 is a region for blocking visible light. In a light blocking region A2a as a portion on the upper edge part 1a side in the light blocking region A2, a far-infrared ray transmission region B and a visible light transmission region C are formed.

The far-infrared ray transmission region B is a region that transmits far-infrared rays, and is a region in which the far-infrared camera CA1 is disposed. That is, the far-infrared camera CA1 is disposed at a position overlapping the far-infrared ray transmission region B when viewed from an optical axis direction of the far-infrared camera CA1. The visible light transmission region C is a region that transmits visible light, and is a region in which the visible light camera CA2 is disposed. That is, the visible light camera CA2 is disposed at a position overlapping the visible light transmission region C when viewed from an optical axis direction of the visible light camera CA2.

As described above, the far-infrared ray transmission region B and the visible light transmission region C are formed in the light blocking region A2, so that the light blocking region A2 blocks far-infrared rays in a region other than the region in which the far-infrared ray transmission region B is formed, and blocks visible light in a region other than the region in which the visible light transmission region C is formed. The light blocking region A2a is formed around the far-infrared ray transmission region B and the visible light transmission region C. It is preferable that various sensors are protected from sunlight due to the light blocking region A2a disposed therearound. This configuration is preferable also in view of design because wiring of various sensors are invisible from the outside of the vehicle.

As illustrated in FIG. 3, the glass 1 for vehicles includes a glass base body 12 (first glass base body), a glass base body 14 (second glass base body), an intermediate layer 16, and a light blocking layer 18. In the glass 1 for vehicles, the glass base body 12, the intermediate layer 16, the glass base body 14, and the light blocking layer 18 are laminated in this order toward the Z-direction. The glass base body 12 and the glass base body 14 are fixed (bonded) to each other via the intermediate layer 16.

As the glass base bodies 12 and 14, for example, soda-lime glass, borosilicate glass, aluminosilicate glass, and the like can be used. The intermediate layer 16 is a bonding layer that bonds the glass base body 12 to the glass base body 14. As the intermediate layer 16, for example, a polyvinyl butyral (hereinafter, also referred to as PVB) modified material, an ethylene-vinyl acetate copolymer (EVA)-based material, a urethane resin material, a vinyl chloride resin material, and the like can be used. More specifically, the glass base body 12 includes one surface 12A and another surface 12B, and the other surface 12B is being in contact with one surface 16A of the intermediate layer 16 to be fixed (bonded) to the intermediate layer 16. The glass base body 14 includes one surface 14A and another surface 14B, and the one surface 14A is being in contact with another surface 16B of the intermediate layer 16 to be fixed (bonded) to the intermediate layer 16. As described above, the glass 1 for vehicles is laminated glass in which the glass base body 12 and the glass base body 14 are laminated. However, the glass 1 for vehicles is not limited to the laminated glass, and may have a configuration including only one of the glass base body 12 and the glass base body 14, for example. In this case, the intermediate layer 16 is not necessarily disposed. In the following description, in a case of not distinguishing the glass base bodies 12 and 14 from each other, each of them is referred to as a glass base body 10.

The light blocking layer 18 includes one surface 18A and another surface 18B, and the one surface 18A is being in contact with and fixed to the other surface 14B of the glass base body 14. The light blocking layer 18 is a layer that blocks visible light. As the light blocking layer 18, for example, a ceramic light blocking layer and a light blocking film can be used. As the ceramic light blocking layer, for example, a ceramic layer made of conventionally known material, such as a black ceramic layer, can be used. As the light blocking film, for example, a light blocking polyethylene terephthalate (PET) film, a light blocking polyethylene naphthalate (PEN) film, a light blocking polymethyl methacrylate (PMMA) film, and the like can be used.

In the present embodiment, a side on which the light blocking layer 18 is disposed of the glass 1 for vehicles is an interior side of the vehicle V (vehicle interior side), and a side on which the glass base body 12 is disposed thereof is an exterior side of the vehicle V (vehicle exterior side), but the embodiment is not limited thereto. The light blocking layer 18 may be disposed on the exterior side of the vehicle V. In a case in which the glass 1 for vehicles is constituted of laminated glass of the glass base bodies 12 and 14, the light blocking layer 18 may be formed between the glass base body 12 and the glass base body 14.

(Light blocking region)

The light blocking region A2 is formed by disposing the light blocking layer 18 on the glass base body 10. That is, the light blocking region A2 is a region in which the glass base body 10 includes the light blocking layer 18. That is, the light blocking region A2 is a region in which the glass base body 12, the intermediate layer 16, the glass base body 14, and the light blocking layer 18 are laminated. On the other hand, the transparent region A1 is a region in which the glass base body 10 does not include the light blocking layer 18. That is, the transparent region A1 is a region in which the glass base body 12, the intermediate layer 16, and the glass base body 14 are laminated, but the light blocking layer 18 is not laminated thereon.

(Far-infrared ray transmission region)

As illustrated in FIG. 3, an opening 19 is formed on the glass 1 for vehicles, the opening 19 passing therethrough from one surface (herein, the surface 12A) to the other surface (herein, the surface 14B) in the Z-direction. A far-infrared ray transmission member 20 is disposed within the opening 19. A region in which the opening 19 is formed and the far-infrared ray transmission member 20 is disposed is the far-infrared ray transmission region B. That is, the far-infrared ray transmission region B is a region in which the opening 19 and the far-infrared ray transmission member 20 placed within the opening 19 are disposed. The light blocking layer 18 does not transmit far-infrared rays, so that the light blocking layer 18 is not disposed in the far-infrared ray transmission region B. That is, in the far-infrared ray transmission region B, the glass base body 12, the intermediate layer 16, the glass base body 14, and the light blocking layer 18 are not disposed, and the far-infrared ray transmission member 20 is disposed in the formed opening 19. The far-infrared ray transmission member 20 will be described later.

(Visible light region)

As illustrated in FIG. 4, similarly to the transparent region A1, the visible light transmission region C is a region in which the glass base body 10 does not include the light blocking layer 18 in the Z-direction. That is, the visible light transmission region C is a region in which the glass base body 12, the intermediate layer 16, and the glass base body 14 are laminated, but the light blocking layer 18 is not laminated thereon.

As illustrated in FIG. 2, the visible light transmission region C is preferably disposed in the vicinity of the far-infrared ray transmission region B. Specifically, the center of the far-infrared ray transmission region B viewed from the Z-direction is assumed to be a center point OB, and the center of the visible light transmission region C viewed from the Z-direction is assumed to be a center point OC. Assuming that the shortest distance between the far-infrared ray transmission region B (opening 19) and the visible light transmission region C viewed from the Z-direction is a distance L, the distance L is preferably larger than 0 mm and equal to or smaller than 100 mm, and more preferably equal to or larger than 10 mm and equal to or smaller than 80 mm. By disposing the visible light transmission region C at a position in this range with respect to the far-infrared ray transmission region B, the far-infrared camera CA1 and the visible light camera CA2 are enabled to take images of near positions, and the visible light camera CA2 can appropriately take an image while suppressing an amount of perspective distortion in the visible light transmission region C. By taking images of near positions by the far-infrared camera CA1 and the visible light camera CA2, a load of performing arithmetic processing on data obtained from each camera is reduced, and a power supply or a signal cable can be preferably handled.

As illustrated in FIG. 2, the visible light transmission region C and the far-infrared ray transmission region B are preferably positioned side by side in the X-direction. That is, it is preferable that the visible light transmission region C is not positioned on the Y-direction side of the far-infrared ray transmission region B, but is positioned side by side with the far-infrared ray transmission region B in the X-direction. By placing the visible light transmission region C side by side with the far-infrared ray transmission region B in the X-direction, the visible light transmission region C can be placed in the vicinity of the upper edge part 1a. Thus, a visual field of the driver in the transparent region A1 can be appropriately secured.

(Far-infrared ray transmission member)

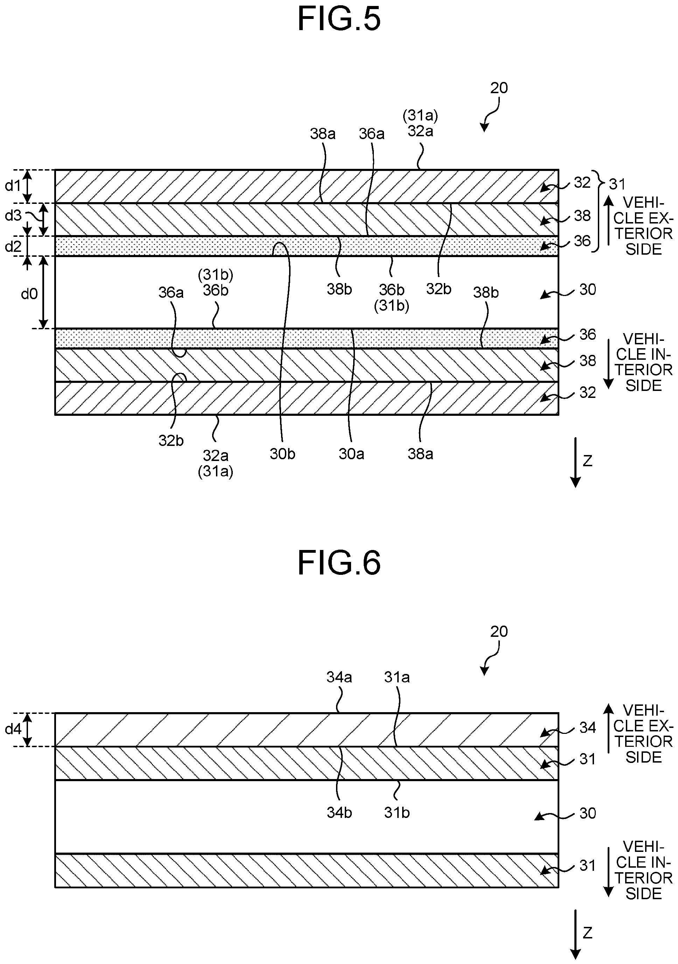

The following specifically describes the far-infrared ray transmission member 20 disposed in the far-infrared ray transmission region B. FIG. 5 is a schematic cross-sectional view of the far-infrared ray transmission member according to the present embodiment. As illustrated in FIG. 5, the far-infrared ray transmission member 20 includes a base material 30 and a functional film 31 formed on the base material 30. In the present embodiment, in the far-infrared ray transmission member 20, functional films 31 are formed on both of one surface 30a and another surface 30b of the base material 30. The surface 30a is a surface on the vehicle interior side in a case of being mounted on the glass 1 for vehicles, and the surface 30b is a surface on the vehicle exterior side in a case of being mounted on the glass 1 for vehicles. However, in the far-infrared ray transmission member 20, the functional films 31 are not necessarily formed on both surfaces 30a and 30b of the base material 30, but the functional film 31 may be formed on at least one of the surfaces 30a and 30b. The functional film 31 is preferably formed at least on the surface 30b on the vehicle exterior side of the surfaces 30a and 30b. That is, it can be said that a film is not necessarily formed on the surface 30a of the base material 30, and the functional film 31 or a film other than the functional film 31 may be formed thereon.

As described above, in the present embodiment, the far-infrared ray transmission member 20 is disposed in the light blocking region A2 of the glass 1 for vehicles as the window member of the vehicle V, but the embodiment is not limited thereto. The far-infrared ray transmission member 20 may be disposed on an optional exterior member of the vehicle V such as an exterior member for a pillar of the vehicle V. The far-infrared ray transmission member 20 is not necessarily disposed in the vehicle V, but may be used for any application.

(Base material)

The base material 30 is a member capable of transmitting far-infrared rays. An internal transmittance of the base material 30 with respect to light at a wavelength of 10 um (far-infrared rays) is preferably equal to or higher than 50%, more preferably equal to or higher than 60%, and even more preferably equal to or higher than 70%. Additionally, an average internal transmittance of the base material 30 with respect to light at a wavelength of 8 um to 12 um (far-infrared rays) is preferably equal to or higher than 50%, more preferably equal to or higher than 60%, and even more preferably equal to or higher than 70%. When the internal transmittance of the base material 30 with respect to 10 um and the average internal transmittance with respect to 8 um to 12 um fall within this numerical range, far-infrared rays can be appropriately transmitted, and performance of the far-infrared camera CA1 can be sufficiently exhibited, for example. Herein, the average internal transmittance is an average value of the internal transmittance with respect to light at each wavelength in the wavelength band (herein, from 8 $\mu$m to 12 $\mu$m).

The internal transmittance of the base material 30 is a transmittance excluding a surface reflection loss on an incident side and an emitting side, and is well-known in the art. The internal transmittance may be measured by using a method that is normally performed. Measurement is performed as follows, for example.

A pair of flat-plate-shaped samples (a first sample and a second sample) that are made of base materials having the same composition and have different thicknesses are prepared. Both surfaces of the flat-plate-shaped sample are assumed to be planes that are parallel with each other and optically polished. Assuming that an external transmittance including a surface reflection loss of the first sample is T1, an external transmittance including a surface reflection loss of the second sample is T2, the thickness of the first sample is Td1 (mm), and the thickness of the second sample is Td2 (mm), where Td1 < Td2, an internal transmittance $\tau$ with a thickness of Tdx (mm) can be calculated by the following expression (1).

$$\tau = \exp[-Tdx \times (\ln T1 - \ln T2)/\Delta Td] \qquad (1)$$

An external transmittance of infrared rays can be measured by a Fourier transform type infrared spectroscopic device (manufactured by Thermo Fisher Scientific Inc., product name: Nicolet 1S10), for example.

A refractive index of the base material 30 with respect to light at a wavelength of 10 um is preferably equal to or larger than 1.5 and equal to or smaller than 4.0, more preferably equal to or larger than 2.0 and equal to or smaller than 4.0, and even more preferably equal to or larger than 2.2 and equal to or smaller than 3.5. An average refractive index of the base material 30 with respect to light at a wavelength of 8 um to 12 um is preferably equal to or larger than 1.5 and equal to or smaller than 4.0, more preferably equal to or larger than 2.0 and equal to or smaller than 4.0, and even more preferably equal to or larger than 2.2 and equal to or smaller than 3.5. When the refractive index and the average refractive index of the base material 30 fall within this numerical range, far-infrared rays can be appropriately transmitted, and performance of the far-infrared camera CA1 can be sufficiently exhibited, for example. Herein, the average refractive index is an average value of the refractive index with respect to light at each wavelength in the wavelength band (herein, from 8 um to 12 um). The refractive index can be determined by performing fitting of an optical model using polarization information obtained by an infrared spectroscopic ellipsometer (manufactured by J.A. Woollam, IR-VASE-UT), for example, and a spectral transmission spectrum obtained by a Fourier transform type infrared spectroscopic device.

A thickness d0 of the base material 30 is preferably equal to or larger than 0.5 mm and equal to or smaller than 5 mm, more preferably equal to or larger than 1 mm and equal to or smaller than 4 mm, and even more preferably equal to or larger than 1.5 mm and equal to or smaller than 3 mm. When the thickness d0 falls within this range, far-infrared rays can be appropriately transmitted while securing strength. It can also be said that the thickness d0 is a length from the surface 30a to the surface 30b of the base material 30 in the Z-direction.

A material of the base material 30 is not particularly limited, but Si, Ge, ZnS, chalcogenide glass, and the like can be exemplified, for example. The base material 30 preferably includes at least one material selected from the group consisting of Si, Ge, ZnS, and chalcogenide glass. By using such a material for the base material 30, far-infrared rays can be appropriately transmitted.

Preferred composition of the chalcogenide glass contains,

in atom percentage,

Ge+Ga; 7% to 25%,
Sb; 0% to 35%,
Bi; 0% to 20%,
Zn; 0% to 20%,
Sn; 0% to 20%,
Si; 0% to 20%,
La; 0% to 20%,
S+Se+Te; 55% to 80%,
Ti; 0.005% to 0.3%,
Li+Na+K+Cs; 0% to 20%, and
F+Cl+Br+I; 0% to 20%.

Additionally, this glass preferably has a glass transition point (Tg) of 140°C to 550°C.

As the material for the base material 30, it is more preferable to use Si or ZnS.

(Functional film)

The functional film 31 is a film that is formed on the base material 30 to suppress reflection of visible light and far-infrared rays.

As illustrated in FIG. 5, the functional film 31 according to the present embodiment includes a visible light absorbing layer 32, a high refractive index layer 36, and a low refractive index layer 38. In the example of FIG. 5, the high refractive index layer 36 and the low refractive index layer 38 are alternately laminated between the base material 30 and the visible light absorbing layer 32. That is, in the functional film 31, the visible light absorbing layer 32 is formed on an outermost side (a side farthest from the base material 30). However, the visible light absorbing layer 32 is not necessarily formed on the outermost side in the functional film 31. The high refractive index layer 36 or the low refractive index layer 38 may be formed on an outer side of the visible light absorbing layer 32.

In the example of FIG. 5, the functional film 31 is laminated on the base material 30 in order of the high refractive index layer 36, the low refractive index layer 38, and the visible light absorbing layer 32 in a direction away from the base material 30. Hereinafter, a surface of the high refractive index layer 36 on the opposite side of the base material 30 is assumed to be a surface 36a, a surface of the high refractive index layer 36 on the base material 30 side is assumed to be a surface 36b, a surface of the low refractive index layer 38 on the opposite side of the base material 30 is assumed to be a surface 38a, a surface of the low refractive index layer 38 on the base material 30 side is assumed to be a surface 38b, a surface of the visible light absorbing layer 32 on the opposite side of the base material 30 is assumed to be a surface 32a, and a surface of the visible light absorbing layer 32 on the base material 30 side is assumed to be a surface 32b. That is, in the example of FIG. 5, the surface 36b of the high refractive index layer 36 is a surface 31b of the functional film 31 on the base material 30 side, and the surface 32a of the visible light absorbing layer 32 is the surface 31b of the functional film 31 on the base material 30 side. However, in the configuration including the visible light absorbing layer 32, the high refractive index layer 36, and the low refractive index layer 38, the layer formed to be closest to the base material 30 is not limited to the high refractive index layer 36, but may be the low refractive index layer 38, for example. For example, the low refractive index layer 38, the high refractive index layer 36, and the visible light absorbing layer 32 may be laminated in this order in the direction away from the base material 30.

In the example of FIG. 5, the functional film 31 has a configuration in which the one high refractive index layer 36, the one low refractive index layer 38, and the one visible light absorbing layer 32 are laminated, but the embodiment is not limited thereto. A plurality of the high refractive index layers 36 or a plurality of the low refractive index layers 38 may be laminated. For example, in the far-infrared ray transmission member 20, the high refractive index layers 36 and the low refractive index layers 38 may be alternately laminated on the base material 30 in the direction away from the base material 30 so that the visible light absorbing layer 32 is disposed on the outermost side (the side farthest from the base material 30). That is, the base material 30, the high refractive index layer 36, the low refractive index layer 38, the high refractive index layer 36, ... the low refractive index layer 38, and the visible light absorbing layer 32 may be laminated in this order. Furthermore, in the far-infrared ray transmission member 20, the high refractive index layer 36 and the low refractive index layer 38 may be alternately laminated on the base material 30 in the direction away from the base material 30 so that the visible light absorbing layer 32 is disposed on the outermost side. That is, the base material 30, the low refractive index layer 38, the high refractive index layer 36, ... the low refractive index layer 38, and the visible light absorbing layer 32 may be laminated in this order.

The functional film 31 may have a layer configuration including the visible light absorbing layer 32 and the high refractive index layer 36 but not including the low refractive index layer 38. In this case, the visible light absorbing layer 32 functions as an intermediate refractive index layer (low refractive index layer) having a lower refractive index than that of the high refractive index layer 36. As the functional film 31, the one high refractive index layer 36 and the one visible light absorbing layer 32 may be laminated in this order on the base material 30, or the one visible light absorbing layer 32 and the one high refractive index layer 36 may be laminated in this order thereon in the direction away from the base material 30. Alternatively, as the functional film 31, a plurality of the visible light absorbing layers 32 or a plurality of the high refractive index layers 36 may be laminated. In this case, for example, as the functional film 31, the visible light absorbing layers 32 and the high refractive index layers 36 may be alternately laminated. On the base material 30, the high refractive index layer 36, the visible light absorbing layer 32, the high refractive index layer 36,..., and the visible light absorbing layer 32 may be laminated in this order, or the visible light absorbing layer 32, the high refractive index layer 36,... and the visible light absorbing layer 32 may be laminated in this order in the direction away from the base material 30.

The functional film 31 may have a layer configuration including the visible light absorbing layer 32 and the low refractive index layer 38 but not including the high refractive index layer 36. In this case, the visible light absorbing layer 32 functions as an intermediate refractive index layer (high refractive index layer) having a higher refractive index than that of the low refractive index layer 38. As the functional film 31, the one visible light absorbing layer 32 and the one low refractive index layer 38 may be laminated in this order on the base material 30, or the one low refractive index layer 38 and the one visible light absorbing layer 32 may be laminated in this order thereon in the direction away from the base material 30. Alternatively, as the functional film 31, a plurality of the visible light absorbing layers 32 or a plurality of the low refractive index layers 38 may be laminated. In this case, for example, as the functional film 31, the visible light absorbing layers 32 and the low refractive index layers 38 may be alternately laminated. On the base material 30, the visible light absorbing layer 32, the low refractive index layer 38, the visible light absorbing layer 32, ..., and the low refractive index layer 38 may be laminated in this order, or the low refractive index layer 38, the visible light absorbing layer 32, ... and the low refractive index layer 38 may be laminated in this order in the direction away from the base material 30.

In a case in which a plurality of layers are laminated as described above, a layer of the functional film 31 closest to the base material 30 is the visible light absorbing layer 32, the high refractive index layer 36, or the low refractive index layer 38, considering a refractive index of the base material and adhesion with respect to the base material. In this way, by laminating the visible light absorbing layers 32, the high refractive index layers 36, and the low refractive index layers 38, a reflectance with respect to light in a wider wavelength range can be suppressed.

The functional film 31 does not necessarily include both of the high refractive index layer 36 and the low refractive index layer 38, and is characterized as including at least one visible light absorbing layer 32. That is, the functional film 31 may be a single layer film including the one visible light absorbing layer 32, and may be a multilayer film in which the visible light absorbing layer 32 and at least one of the high refractive index layer 36 and the low refractive index layer 38 are laminated. By causing the functional film 31 to be an antireflection film having a multilayer structure, it is possible to easily implement a low reflectance in a wide wavelength region using interferential action of light due to interface reflected light generated on each interface. In the functional film 31 having the multilayer structure, the visible light absorbing layer 32 is preferably placed on a side farthest from the base material 30.

The functional film 31 formed on the vehicle interior side of the base material 30 and the functional film 31 formed on the vehicle exterior side thereof may have different layer configurations.

(Visible light absorbing layer)

A refractive index of the visible light absorbing layer 32 with respect to light (visible light) at a wavelength of 550 nm is preferably equal to or larger than 1.5 and equal to or smaller than 4.0, more preferably equal to or larger than 1.7 and equal to or smaller than 3.5, and even more preferably equal to or larger than 2.0 and equal to or smaller than 2.5. An average refractive index of the visible light absorbing layer 32 with respect to light at a wavelength of 380 nm to 780 nm is preferably equal to or larger than 1.5 and equal to or smaller than 4.0, more preferably equal to or larger than 1.7 and equal to or smaller than 3.5, and even more preferably equal to or larger than 2.0 and equal to or smaller than 2.5. When the refractive index and the average refractive index of the visible light absorbing layer 32 with respect to visible light fall within this numerical range, reflection of visible light can be suppressed, and the far-infrared ray transmission member 20 is enabled to be inconspicuous. The refractive index of light at a wavelength of 550 nm can be determined by performing fitting of an optical model using polarization information obtained by spectroscopic ellipsometer (manufactured by J.A. Woollam, M-2000), for example, and a spectral transmittance that is measured based on JIS R3106.

An extinction coefficient of the visible light absorbing layer 32 with respect to light at a wavelength of 550 nm is preferably equal to or larger than 0.04, more preferably equal to or larger than 0.05, even more preferably equal to or larger than 0.06, further more preferably equal to or larger than 0.07, further more preferably equal to or larger than 0.08, and further more preferably equal to or larger than 0.10. An average extinction coefficient of the visible light absorbing layer 32 with respect to light at wavelength of 380 nm to 780 nm is preferably equal to or larger than 0.04, more preferably equal to or larger than 0.05, even more preferably equal to or larger than 0.06, further more preferably equal to or larger than 0.07, further more preferably equal to or larger than 0.08, and further more preferably equal to or larger than 0.10. When the extinction coefficient and the average extinction coefficient fall within this range, reflectance dispersion of visible light can be appropriately suppressed, and external appearance ensuring design can be achieved. The average extinction coefficient is an average value of the extinction coefficient with respect to light at each wavelength in the wavelength band (herein, from 380 nm to 780 nm). The extinction coefficient with respect to light at a wavelength of 550 nm can be determined by performing fitting of an optical model using polarization information obtained by a spectroscopic ellipsometer, for example, and a spectral transmittance that is measured based on JIS R3106.

The refractive index of the visible light absorbing layer 32 with respect to light (far-infrared rays) at a wavelength of 10 um is preferably equal to or larger than 1.5 and equal to or smaller than 4.0, more preferably equal to or larger than 1.7 and equal to or smaller than 3.0, and even more preferably equal to or larger than 2.0 and equal to or smaller than 2.5. The average refractive index of the visible light absorbing layer 32 with respect to light at a wavelength of 8 um to 12 um is preferably equal to or larger than 1.5 and equal to or smaller than 4.0, more preferably equal to or larger than 1.7 and equal to or smaller than 3.0, and even more preferably equal to or larger than 2.0 and equal to or smaller than 2.5. When the refractive index and the average refractive index of the visible light absorbing layer 32 with respect to far-infrared rays fall within this numerical range, reflection of far-infrared rays can be suppressed, and far-infrared rays can be appropriately transmitted. The refractive index with respect to light at a wavelength of 8 um to 12 $\mu$m can be determined by performing fitting of an optical model using polarization information obtained by an infrared spectroscopic ellipsometer (manufactured by J.A. Woollam, IR-VASE-UT), for example, and a spectral transmission spectrum obtained by a Fourier transform type infrared spectroscopic device (manufactured by Thermo Fisher Scientific Inc., Nicolet iS10).

The visible light absorbing layer 32 can transmit far-infrared rays. The extinction coefficient of the visible light absorbing layer 32 with respect to light at a wavelength of 10 um is preferably equal to or smaller than 0.1, preferably equal to or smaller than 0.05, and more preferably equal to or smaller than 0.02. The average extinction coefficient of the visible light absorbing layer 32 with respect to light at a wavelength of 8 um to 12 um is preferably equal to or smaller than 0.1, preferably equal to or smaller than 0.05, and more preferably equal to or smaller than 0.02. When the extinction coefficient and the average extinction coefficient fall within this range, far-infrared rays can be appropriately transmitted. The extinction coefficient with respect to light at a wavelength of 8 um to 12 um can be determined by, for example, performing fitting of an optical model using polarization information obtained by an infrared spectroscopic ellipsometer and a spectral transmission spectrum obtained by a Fourier transform type infrared spectroscopic device.

A thickness d1 of the visible light absorbing layer 32 is preferably equal to or larger than 0.1 $\mu$m and equal to or smaller than 2.0 $\mu$m, more preferably equal to or larger than 0.5 $\mu$m and equal to or smaller than 1.5 um, and even more preferably equal to or larger than 0.8 um and equal to or smaller than 1.4 um. When the thickness d1 falls within this range, dispersion and reflection of visible light can be appropriately suppressed while appropriately suppressing reflection of far-infrared rays. It can also be said that the thickness d1 is a length from the surface 32a of the visible light absorbing layer 32 to the surface 32b on the opposite side in the Z-direction.

A material of the visible light absorbing layer 32 is optional, but metal oxide is preferably contained therein as a principal component. Herein, the principal component indicates that a content thereof with respect to the entire visible light absorbing layer 32 is equal to or larger than 50 mass%. As the metal oxide used for the visible light absorbing layer 32, at least one of nickel oxide ($NiO_x$), copper oxide ($CuO_x$), and manganese oxide ($MnO_x$) is preferably used. The visible light absorbing layer 32 preferably contains at least one material selected from the group consisting of $NiO_x$, $CuO_x$, and $MnO_x$ as the principal component. It is preferable that the visible light absorbing layer 32 contains $NiO_x$ as the principal component, or contains at least one material selected from the group consisting of $CuO_x$ and $MnO_x$ as the

principal component. Nickel oxide, copper oxide, and manganese oxide are known to have a plurality of compositions depending on a valence of nickel, copper, and manganese, and x may take an optional value from 0.5 to 2. The valence is not necessarily single, and two or more valences may be mixed. In the present embodiment, NiO is preferably used as $NiO_x$, CuO is preferably used as $CuO_x$, and MnO is preferably used as $MnO_x$. However, the material of the visible light absorbing layer 32 is not limited thereto, but is optional. For example, the material thereof may be diamond-like carbon.

(High refractive index layer)

The high refractive index layer 36 is a film that is laminated with the visible light absorbing layer 32 and the low refractive index layer 38 to suppress reflection of far-infrared rays. In the present embodiment, the high refractive index layer 36 is laminated to be closer to the base material 30 than the visible light absorbing layer 32, and is disposed between the base material 30 and the low refractive index layer 38 in the example of FIG. 5. In a case in which the low refractive index layer 38 is not formed, the high refractive index layer 36 is disposed between the base material 30 and the visible light absorbing layer 32.

The high refractive index layer 36 is a film having a high refractive index with respect to far-infrared rays. The refractive index with respect to light at a wavelength of 10 um is higher than that of the visible light absorbing layer 32, preferably equal to or larger than 2.5 and equal to or smaller than 4.5, more preferably equal to or larger than 3.0 and equal to or smaller than 4.5, and even more preferably equal to or larger than 3.3 and equal to or smaller than 4.3. The average refractive index of the high refractive index layer 36 with respect to light at a wavelength of 8 um to 12 um is higher than that of the visible light absorbing layer 32, preferably equal to or larger than 2.5 and equal to or smaller than 4.5, more preferably equal to or larger than 3.0 and equal to or smaller than 4.5, and even more preferably equal to or larger than 3.3 and equal to or smaller than 4.3. When the refractive index and the average refractive index of the high refractive index layer 36 fall within this numerical range, the high refractive index layer 36 can appropriately function as a high refractive index film and appropriately suppress reflection of far-infrared rays.

The high refractive index layer 36 can transmit far-infrared rays. The extinction coefficient of the high refractive index layer 36 with respect to light at a wavelength of 10 um is preferably equal to or smaller than 0.05, preferably equal to or smaller than 0.02, and more preferably equal to or smaller than 0.01. The average extinction coefficient of the high refractive index layer 36 with respect to light at a wavelength of 8 um to 12 um is preferably equal to or smaller than 0.05, preferably equal to or smaller than 0.02, and more preferably equal to or smaller than 0.01. When the extinction coefficient and the average extinction coefficient fall within this range, far-infrared rays can be appropriately transmitted.

A thickness d2 of the high refractive index layer 36 is preferably equal to or larger than 0.1 um and equal to or smaller than 2.0 um, more preferably equal to or larger than 0.2 um and equal to or smaller than 1.5 um, and even more preferably equal to or larger than 0.3 um and equal to or smaller than 1.2 um. When the thickness d2 falls within this range, reflection of far-infrared rays can be appropriately suppressed. It can also be said that the thickness d2 is a length from the surface 36a of the high refractive index layer 36 to the surface 36b on the opposite side in the Z-direction.

A material of the high refractive index layer 36 may be optional, but at least one material selected from the group consisting of Si and Ge is preferably contained therein as a principal component.

(Low refractive index layer)

The low refractive index layer 38 is a film that is laminated with the visible light absorbing layer 32 and the high refractive index layer 36 to suppress reflection of far-infrared rays. In the present embodiment, the low refractive index layer 38 is laminated to be closer to the base material 30 than the visible light absorbing layer 32, and is disposed between the high refractive index layer 36 and the visible light absorbing layer 32 in the example of FIG. 5. In a case in which the high refractive index layer 36 is not formed, the low refractive index layer 38 is disposed between the base material 30 and the visible light absorbing layer 32.

The low refractive index layer 38 is a film having a low refractive index with respect to far-infrared rays. The refractive index with respect to light at a wavelength of 10 um is lower than that of the visible light absorbing layer 32, preferably equal to or larger than 0.8 and equal to or smaller than 2.0, more preferably equal to or larger than 1.0 and equal to or smaller than 1.7, and even more preferably equal to or larger than 1.0 and equal to or smaller than 1.5. The average refractive index of the low refractive index layer 38 with respect to light at a wavelength of 8 um to 12 um is lower than that of the visible light absorbing layer 32, preferably equal to or larger than 0.8 and equal to or smaller than 2.0, more preferably equal to or larger than 1.0 and equal to or smaller than 1.7, and even more preferably equal to or larger than 1.0 and equal to or smaller than 1.5. When the refractive index and the average refractive index of the low refractive index layer 38 fall within this numerical range, the low refractive index layer 38 can appropriately function as a low refractive index film and appropriately suppress reflection of far-infrared rays.

The low refractive index layer 38 can transmit far-infrared rays. The extinction coefficient of the low refractive index layer 38 with respect to light at a wavelength of 10 $\mu$m is preferably equal to or smaller than 0.05, preferably equal to or smaller than 0.02, and more preferably equal to or smaller than 0.01. The average extinction coefficient of the low refractive index layer 38 with respect to light at a wavelength of 8 um to 12 um is preferably equal to or smaller than 0.05, preferably equal to or smaller than 0.02, and more preferably equal to or smaller than 0.01. When the extinction coefficient and the average extinction coefficient fall within this range, far-infrared rays can be appropriately transmitted.

A thickness d3 of the low refractive index layer 38 is preferably equal to or larger than 0.1 $\mu$m and equal to or smaller than 2.0 $\mu$m, more preferably equal to or larger than 0.2 $\mu$m and equal to or smaller than 1.7 $\mu$m, and even more preferably equal to or larger than 0.3 um and equal to or smaller than 1.5 $\mu$m. When the thickness d3 falls within this range, reflection of far-infrared rays can be appropriately suppressed. It can also be said that the thickness d3 is a length from a surface 38a of the low refractive index layer 38 to a surface 38b on the opposite side in the Z-direction.

It is preferable that the low refractive index layer 38 is a film containing oxide as a principal component. More specifically, the low refractive index layer 38 preferably contains MgO as the oxide, MgO being the principal component. A content of MgO in the low refractive index layer 38 is preferably equal to or larger than 50 mass% and equal to or smaller than 100 mass%, more preferably equal to or larger than 70 mass% and equal to or smaller than 100 mass%, and even more preferably equal to or larger than 85 mass% and equal to or smaller than 100 mass% with respect to the entire low refractive index layer 38. When the content of MgO falls within this range, the low refractive index layer 38 can appropriately transmit far-infrared rays, have a low refractive index with respect to far-infrared rays, and appropriately suppress reflection of far-infrared rays.

The low refractive index layer 38 may also contain an accessory component as a component other than the oxide (herein, MgO) as the principal component. As the accessory component, oxide that transmits infrared rays is preferable, and $NiO_x$, $CuO_x$, ZnO, $ZrO_2$, $Bi_2O_3$, $Y_2O_3$ can be exemplified.

(Characteristic of far-infrared ray transmission member)

The far-infrared ray transmission member 20 is obtained by forming the functional film 31 including the at least one visible light absorbing layer 32 on the surface of the base material 30 as described above. When the functional film 31 including the visible light absorbing layer 32 is formed on the surface of the base material 30, design of the far-infrared ray transmission member 20 can be ensured by suppressing the reflectance with respect to visible light and reflectance dispersion while appropriately transmitting far-infrared rays.

A transmittance of the far-infrared ray transmission member 20 with respect to light at 10 um is preferably equal to or higher than 50%, more preferably equal to or higher than 65%, and even more preferably equal to or higher than 70%. An average transmittance of the far-infrared ray transmission member 20 with respect to light at a wavelength of 8 um to 12 um is preferably equal to or higher than 50%, more preferably equal to or higher than 65%, and even more preferably equal to or higher than 70%. When the transmittance and the average transmittance fall within this range, a function as an infrared ray transmission member can be appropriately exhibited.

A reflectance of the far-infrared ray transmission member 20 with respect to light at 10 um is preferably equal to or lower than 15%, more preferably equal to or lower than 10%, and even more preferably equal to or lower than 5%. An average reflectance of the far-infrared ray transmission member 20 with respect to light at a wavelength of 8 um to 12 um is preferably equal to or lower than 15%, more preferably equal to or lower than 10%, and even more preferably equal to or lower than 5%. When the reflectance and the average reflectance fall within this range, a function as an infrared ray transmission member can be appropriately exhibited. The average reflectance is an average value of the reflectance with respect to light at each wavelength in the wavelength band (herein, from 8 $\mu$m to 12 $\mu$m). The reflectance can be measured by a Fourier transform type infrared spectroscopic device (manufactured by Thermo Fisher Scientific Inc., Nicolet 1S10), for example.

The reflectance of the far-infrared ray transmission member 20 with respect to visible light defined by JIS R3106 is equal to or lower than 25%, preferably equal to or lower than 20%, and more preferably equal to or lower than 18%. When the reflectance with respect to visible light falls within this range, glare of the far-infrared ray transmission member 20 is suppressed, and design thereof is ensured.

Regarding the far-infrared ray transmission member 20, dispersion D of reflectances with respect to pieces of light at a wavelength of 360 nm to 830 nm in increments of 1 nm is equal to or smaller than 30, more preferably equal to or smaller than 25, even more preferably equal to or smaller than 20, further more preferably equal to or smaller than 15, further more preferably equal to or smaller than 10, and further more preferably equal to or smaller than 5. In other words, the dispersion D indicates dispersion of the reflectances of the far-infrared ray transmission member 20 with respect to respective pieces of light at wavelengths different by 1 nm in a range of the wavelength from 360 nm to 830 nm (that is, pieces of light at a wavelength of 360 nm, 361 nm, 362 nm, ... and 830 nm). That is, assuming that the reflectance of the far-infrared ray transmission member 20 with respect to each piece of light is x, an average value of reflectances of the far-infrared ray transmission member 20 with respect to respective pieces of light at wavelengths different by 1 nm in the range of the wavelength from 360 nm to 830 nm is $\mu$, and a total number of pieces of light in increments of 1 nm in the range of the wavelength from 360 nm to 830 nm is n, the dispersion D is represented by the following expression (2). The reflectances with respect to the respective pieces of light at a wavelength of 360 nm to 830 nm in increments of 1 nm may be measured based on JIS R3106.

$$D = \frac{1}{n}\sum_{i=1}^{n}(x_i - \mu)^2 \qquad (2)$$

When the dispersion D falls within the numerical range described above, a difference between the reflectances with respect to pieces of visible light at different wavelengths is reduced, an interference color of the far-infrared ray transmission member 20 is suppressed, and the design is ensured.

As illustrated in FIG. 3, a surface on the vehicle exterior side of the far-infrared ray transmission member 20 is preferably formed to be flush with (continuous to) a surface on the vehicle exterior side of the light blocking region A2. In other words, a surface 20A on the vehicle exterior side of the far-infrared ray transmission member 20 is attached to be continuous to the surface 12A of the glass base body 12. In this way, when the surface 20A of the far-infrared ray transmission member 20 is continuous to the surface 12A of the glass base body 12, a wiping effect of wipers can be prevented from being deteriorated. Furthermore, it is possible to prevent designability of the vehicle V from being deteriorated due to a level difference, and prevent dust and the like from accumulating on the level difference. Additionally, the far-infrared ray transmission member 20 is preferably shaped in accordance with a curved surface shape of the glass 1 for vehicles to be applied. A method for shaping the far-infrared ray transmission member 20 is not particularly limited, but polishing or mold molding is selected in accordance with a curved surface shape or a member.

The shape of the far-infrared ray transmission member 20 is not particularly limited, but may be preferably a plate shape matching the shape of the opening 19. That is, in a case in which the opening 19 has a circular shape, for example, the far-infrared ray transmission member 20 may have a disc shape (cylinder shape). In view of design, a surface shape of the far-infrared ray transmission member 20 on the vehicle exterior side may be processed to match a curvature of an outer surface shape of the glass base body 12. Furthermore, to achieve both of widening of a viewing angle of the far-infrared camera CA1 and improvement of mechanical characteristics, for example, the far-infrared ray transmission member 20 may be caused to have a lens shape. Such a configuration is preferable because far-infrared light can be efficiently collected even if the area of the far-infrared ray transmission member 20 is small. In this case, the number of far-infrared ray transmission members 20 having the lens shape is preferably 1 to 3, and typically preferably 2. Furthermore, it is particularly preferable that the far-infrared ray transmission member 20 having the lens shape is aligned and modularized in advance, and integrated with a housing for bonding the far-infrared camera CA1 to the glass 1 for vehicles, or a bracket.

The glass 1 for vehicles according to the present embodiment is preferably configured such that an area of the opening 19 on the surface on the vehicle interior side is smaller than an area of the opening 19 on the surface on the vehicle exterior side, and accordingly, an area of the surface on the vehicle interior side of the far-infrared ray transmission member 20 is preferably smaller than an area of the surface on the vehicle exterior side thereof. Such a configuration improves strength against impact from the vehicle exterior side. More specifically, in a case in which the glass 1 for vehicles according to the present embodiment is laminated glass including the glass base body 12 (vehicle exterior side) and the glass base body 14 (vehicle interior side), the opening 19 is formed by an opening 12a of the glass base body 12 and an opening 14a of the glass base body 14 overlapping each other. In this case, an area of the opening 12a of the glass base body 12 may be caused to be larger than an area of the opening 14a of the glass base body 14, and the far-infrared ray transmission member 20 matching the size of the opening 12a of the glass base body 12 may be placed in the opening 12a of the glass base body 12.

As illustrated in FIG. 3, regarding the far-infrared ray transmission member 20, a length D1 of the longest straight line among straight lines each connecting optional two points in the surface on the vehicle exterior side is preferably equal to or smaller than 80 mm. The length D1 is more preferably equal to or smaller than 70 mm, and even more preferably equal to or smaller than 65 mm. The length D1 is also preferably equal to or larger than 60 mm. As illustrated in FIG. 3, regarding the opening 19 in the far-infrared ray transmission region B, a length D2 of the longest straight line among straight lines each connecting optional two points in the surface on the vehicle exterior side is preferably equal to or smaller than 80 mm. The length D2 is more preferably equal to or smaller than 70 mm, and even more preferably equal to or smaller than 65 mm. The length D2 is also preferably equal to or larger than 60 mm. It can also be said that the length D2 is the length of the longest straight line among straight lines each connecting optional two points on an outer circumference of the opening 19 on the surface on the vehicle exterior side (surface 12A) of the glass 1 for vehicles. By causing the length D1 of the far-infrared ray transmission member 20 and the length D2 of the opening 19 to fall within this range, the strength of the glass 1 for vehicles can be prevented from being reduced, and the amount of perspective distortion in the periphery of the opening 19 can be suppressed. Each of the lengths D1 and D2 is a length corresponding to a diameter of the surface on the vehicle exterior side in a case in which the surface on the vehicle exterior side of the far-infrared ray transmission member 20 has a circular shape. Herein, each of the lengths D1 and D2 indicates a length in a state in which the glass 1 for vehicles is mounted on the vehicle V. For example, in a case of performing bending processing on the glass to have a shape to be mounted on the vehicle V, each of the lengths D1 and D2 is a length in a state after the bending processing is performed. The same applies to the description about dimensions and positions other than the lengths D1 and D2 unless otherwise noted.

(Method for manufacturing infrared ray transmission member)

Next, the following describes a method for manufacturing the far-infrared ray transmission member 20. In manufacturing the far-infrared ray transmission member 20, the base material 30 is prepared, and the functional film 31 is formed on the surface of the base material 30. In the present embodiment, the functional film 31 is formed on the surface of the base material 30 by sputtering. In this way, the far-infrared ray transmission member 20 is manufactured. By forming the functional film 31 by sputtering, adhesion of the film can be improved. In this manufacturing method, in a case in which the visible light absorbing layer 32 of the functional film 31 is $NiO_x$, the functional film 31 is formed on the surface of the base material 30 while being heated at a temperature equal to or higher than 100°C and equal to or lower than 300°C. Due to this, the extinction coefficient of the visible light absorbing layer 32 in the functional film 31 with respect to visible light is caused to be an appropriate value, and transmissivity for far-infrared rays is improved, so that absorption of visible light and transmission of far-infrared rays can be appropriately balanced. However, the method for manufacturing the far-infrared ray transmission member 20 is not limited thereto. For example, the functional film 31 is not necessarily formed by sputtering, but may be formed by vapor deposition, for example. The functional film 31 contains oxide as a principal component, so that a forming method therefor is not limited to vapor deposition, and the functional film 31 can be preferably formed by various methods. Specifically, by forming the functional film 31 by sputtering, productivity and adhesion of the film can be improved. Additionally, in the atmosphere, annealing may be performed at a temperature equal to or higher than 100°C and equal to or lower than 300°C.

In a case in which the visible light absorbing layer 32 of the functional film 31 is $CuO_x$, when the functional film 31 is formed on the surface of the base material 30, annealing is preferably performed at a temperature equal to or higher than 100°C and equal to or lower than 600°C for a time equal to or longer than 0.5 hours and equal to or shorter than 2 hours in the atmosphere. Due to this, the extinction coefficient of the visible light absorbing layer 32 in the functional film 31 with respect to visible light is caused to be an appropriate value, and transmissivity for far-infrared rays is improved, so that absorption of visible light and transmission of far-infrared rays can be appropriately balanced.

(Other examples of present embodiment)

In the present embodiment, the far-infrared ray transmission member 20 has the configuration in which only the functional film 31 is formed on the base material 30, but the embodiment is not limited thereto. The following describes other examples of the far-infrared ray transmission member 20.

FIG. 6 is a schematic cross-sectional view of the far-infrared ray transmission member according to another example of the present embodiment. As illustrated in FIG. 6, in the far-infrared ray transmission member 20, a protective film 34 may be formed on the surface 31a of the functional film 31 on the opposite side of the base material 30. The protective film 34 is a film that is formed on an outer surface of the far-infrared ray transmission member 20, that is, an outermost surface exposed to the outside, and protects the functional film 31 against damage caused by wiping of wipers or dust. In the present embodiment, the protective film 34 is disposed on the functional film 31 on the vehicle exterior side, that is, on the outer surface on the vehicle exterior side of the far-infrared ray transmission member 20, and is not disposed on the vehicle interior side. However, the protective film 34 may also be disposed on the functional film 31 on the vehicle interior side, that is, on an outer surface on the vehicle interior side of the far-infrared ray transmission member 20. In the example of FIG. 6, for convenience of explanation, the functional film 31 is illustrated as a single layer, but the functional film 31 is not limited to the single layer. The functional film 31 may have any of the layer configurations described above.

(Protective film)

The protective film 34 is preferably a film harder than the functional film 31. Specifically, the protective film 34 preferably has nanoindentation hardness higher than that of the functional film 31. By forming the hard protective film 34 on the surface, the functional film 31 can be appropriately protected against damage caused by wiping of wipers or dust. The nanoindentation hardness can be measured by a nanoindenter (manufactured by TOYO Corporation, nanoindenter iMicro), for example.

The refractive index of the protective film 34 with respect to light (visible light) at a wavelength of 550 nm is preferably equal to or smaller than 2.5, more preferably equal to or larger than 1.5 and equal to or smaller than 2.5, and even more preferably equal to or larger than 1.7 and equal to or smaller than 2.4. The average refractive index of the protective film 34 with respect to light at a wavelength of 380 nm to 780 nm is preferably equal to or smaller than 2.5, more preferably equal to or larger than 1.5 and equal to or smaller than 2.5, and even more preferably equal to or larger than 1.7 and equal to or smaller than 2.4. When the refractive index and the average refractive index of the protective film 34 with respect to visible light fall within this numerical range, reflection of visible light can be suppressed by a combination of the protective film 34 and the visible light absorbing layer 32, and the far-infrared ray transmission member 20 is enabled to be inconspicuous. The refractive index of the protective film 34 with respect to light at a wavelength of 550 nm is preferably equal to or smaller than the refractive index of the visible light absorbing layer 32 with respect to light at a wavelength of 550 nm, and the average refractive index of the protective film 34 with respect to light at a wavelength of 380 nm to 780 nm is preferably equal to or smaller than the average refractive index of the visible light absorbing layer 32 with respect to light at a wavelength of 380 nm to 780 nm.

The refractive index of the protective film 34 with respect to light (far-infrared rays) at a wavelength of 10 um is preferably equal to or larger than 0.5 and equal to or smaller than 3.5, more preferably equal to or larger than 0.7 and equal to or smaller than 2.5, and even more preferably equal to or larger than 1.0 and equal to or smaller than 2.5. The average refractive index of the protective film 34 with respect to light at a wavelength of 8 um to 12 um is preferably equal to or larger than 0.5 and equal to or smaller than 3.5, more preferably equal to or larger than 0.7 and equal to or smaller than 2.5, and even more preferably equal to or larger than 1.0 and equal to or smaller than 2.5. When the refractive index and the average refractive index of the protective film 34 with respect to far-infrared rays fall within this numerical range, reflection of far-infrared rays can be suppressed, and far-infrared rays can be appropriately transmitted.

The protective film 34 can transmit far-infrared rays. The extinction coefficient of the protective film 34 with respect to light at a wavelength of 10 um is preferably equal to or smaller than 0.4, preferably equal to or smaller than 0.2, and more preferably equal to or smaller than 0.1. The average extinction coefficient of the protective film 34 with respect to light at a wavelength of 8 $\mu$m to 12 $\mu$m is preferably equal to or smaller than 0.4, preferably equal to or smaller than 0.2, and more preferably equal to or smaller than 0.1. When the extinction coefficient and the average extinction coefficient fall within this range, far-infrared rays can be appropriately transmitted.

A thickness d4 of the protective film 34 is preferably equal to or larger than 0.01 $\mu$m and equal to or smaller than 1 $\mu$m, more preferably equal to or larger than 0.02 $\mu$m and equal to or smaller than 0.5 $\mu$m, and even more preferably equal to or larger than 0.05 $\mu$m and equal to or smaller than 0.3 um. When the thickness d2 falls within this range, reflection of far-infrared rays and visible light can be appropriately suppressed. It can also be said that the thickness d2 is a length from a surface 34a of the protective film 34 to a surface 34b on the opposite side in the Z-direction.

A material of the protective film 34 is optional, but preferably contains at least one material selected from the group consisting of $ZrO_2$, $Al_2O_3$, $TiO_2$, $Si_3N_4$, AlN, and diamond-like carbon, for example. By using such a material, the protective film 34 can appropriately protect the functional film 31.

The protective film 34 preferably has a water barrier property to protect the functional film 31 from water. That is, the protective film 34 preferably protects the functional film 31 from water to keep external appearance of the functional film 31 in a visible light region. Water barrier performance of the protective film 34 varies depending on a material, a crystal structure, and a film thickness. In view of the water barrier property, the protective film 34 preferably has an amorphous structure.

Similarly to the functional film 31, the protective film 34 may also be formed by sputtering, but the embodiment is not limited thereto. The protective film 34 may be formed by vapor deposition, for example.

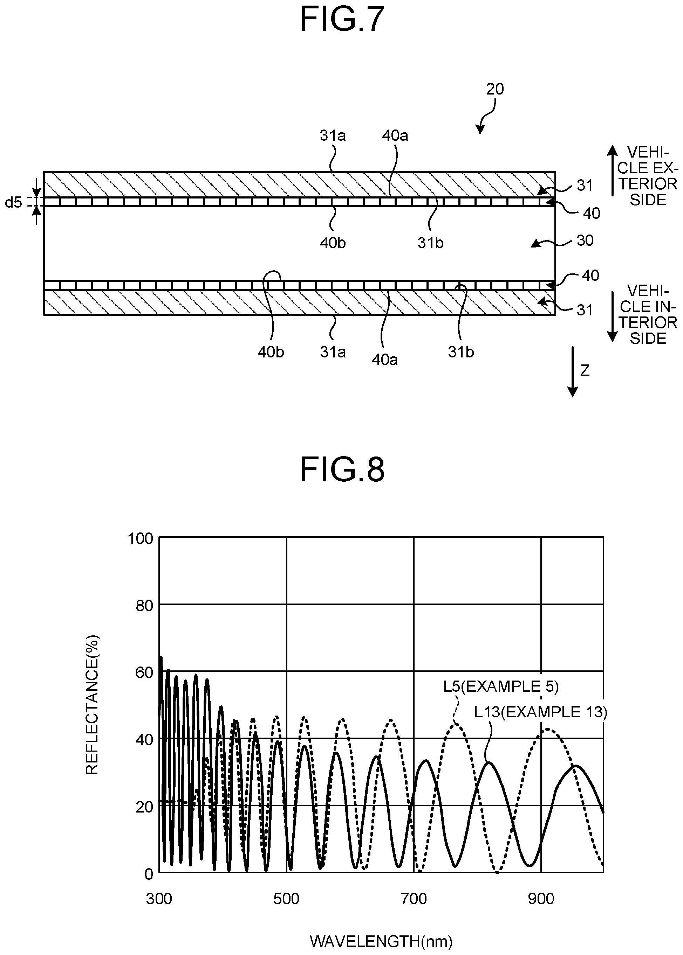

FIG. 7 is a schematic cross-sectional view of the far-infrared ray transmission member according to another example of the present embodiment. As illustrated in FIG. 7, in the far-infrared ray transmission member 20, an adhesive film 40 may be formed between the functional film 31 and the base material 30. Also in the example of FIG. 7, the protective film 34 as in the example of FIG. 6 may be formed on the outer surface. Also in the example of FIG. 7, the functional film 31 is illustrated as a single layer, but the functional film 31 is not limited to the single layer. The functional film 31 may have any of the layer configurations described above.

(Adhesive film)

The adhesive film 40 is a film for causing the base material 30 and the functional film 31 to adhere to each other, in other words, a film for improving adhesive strength between the base material 30 and the functional film 31. The adhesive film 40 is disposed between the base material 30 and the functional film 31.

A refractive index of the adhesive film 40 with respect to light (far-infrared rays) at a wavelength of 10 um is preferably equal to or larger than 1.0 and equal to or smaller than 4.3, more preferably equal to or larger than 1.5 and equal to or smaller than 4.3, and even more preferably equal to or larger than 1.5 and equal to or smaller than 3.8. An average refractive index of the adhesive film 40 with respect to light at a wavelength of 8 um to 12 um is preferably equal to or larger than 1.0 and equal to or smaller than 4.3, more preferably equal to or larger than 1.5 and equal to or smaller than 4.3, and even more preferably equal to or larger than 1.5 and equal to or smaller than 3.8. When the refractive index and the average refractive index of the adhesive film 40 with respect to far-infrared rays fall within this numerical range, reflection of far-infrared rays can be suppressed, and far-infrared rays can be appropriately transmitted.

The adhesive film 40 can transmit far-infrared rays. An extinction coefficient of the adhesive film 40 with respect to light at a wavelength of 10 um is preferably equal to or smaller than 0.4, more preferably equal to or smaller than 0.2, and even more preferably equal to or smaller than 0.1. An average extinction coefficient of the adhesive film 40 with respect to light at a wavelength of 8 um to 12 um is preferably equal to or smaller than 0.4, preferably equal to or smaller than 0.2, and more preferably equal to or smaller than 0.1. When the extinction coefficient and the average extinction coefficient fall within this range, far-infrared rays can be appropriately transmitted.

A thickness d5 of the adhesive film 40 is preferably equal to or larger than 0.05 um and equal to or smaller than 0.5 um, more preferably equal to or larger than 0.05 um and equal to or smaller than 0.3 um, and even more preferably equal to or larger than 0.05 um and equal to or smaller than 0.1 um. When the thickness d5 falls within this range, reflection of far-infrared rays and visible light can be appropriately suppressed. It can also be said that the thickness d5 is a length from a surface 40a of the adhesive film 40 to a surface 40b on the opposite side in the Z-direction. The thickness d5 of the adhesive film 40 is preferably smaller than the thickness d1 of the visible light absorbing layer 32, the thickness d2 of the high refractive index layer 36, and the thickness d3 of the low refractive index layer 38. Due to the thickness d5 of the adhesive film 40 smaller than the thicknesses of these layers, influence on optical performance can be reduced.

A material of the adhesive film 40 is optional, but preferably contains at least one material selected from the group consisting of Si, Ge, MgO, $NiO_x$, $CuO_x$, ZnS, $Al_2O_3$, $ZrO_2$, $SiO_2$, $TiO_2$, ZnO, and $Bi_2O_3$, for example. By using such a material, the adhesive film 40 can cause the base material 30 and the functional film 31 to appropriately adhere to each other.

Similarly to the functional film 31, the adhesive film 40 may also be formed by sputtering, but the embodiment is not limited thereto. The adhesive film 40 may be formed by vapor deposition, for example.

(Effects)

As described above, the far-infrared ray transmission member 20 according to the present embodiment includes the base material 30 that transmits far-infrared rays and the functional film 31 formed on the base material 30. The dispersion D of the reflectances with respect to pieces of light at a wavelength of 360 nm to 830 nm in increments of 1 nm is equal to or smaller than 30, the reflectance with respect to the visible light defined by JIS R3106 is equal to or lower than 25%, and the average transmittance with respect to light at a wavelength of 8 um to 12 um is equal to or higher than 50%. Herein, the far-infrared ray transmission member is required to appropriately transmit far-infrared rays. Additionally, there may be a case in which the far-infrared ray transmission member is required to be inconspicuous in view of design when being disposed to be exposed to the outside, for example. On the other hand, the far-infrared ray transmission member 20 according to the present embodiment can appropriately transmit far-infrared rays when the average transmittance with respect to light at a wavelength of 8 um to 12 um is equal to or higher than 50%. Furthermore, the far-infrared ray transmission member 20 can suppress intensity of reflected light of visible light when the reflectance with respect to visible light is equal to or lower than 25%. Additionally, regarding the far-infrared ray transmission member 20, a difference between the reflectances with respect to pieces of visible light at different wavelengths is reduced, and an interference color can be prevented from being visually recognized when the dispersion D is equal to or smaller than 30. Thus, the far-infrared ray transmission member 20 is hardly visually recognized by a person, and becomes inconspicuous. Particularly, the far-infrared ray transmission member 20 may be placed in the light blocking region A2 made of black ceramics and the like in some cases, so that the far-infrared ray transmission member 20 preferably has a high affinity for the light blocking region A2 in view of external appearance. As described above, the far-infrared ray transmission member 20 has a low reflectance with respect to visible light and small dispersion D, so that the far-infrared ray transmission member 20 has a high affinity for the light blocking region A2 in view of external appearance, and the design is ensured.

The average transmittance of the far-infrared ray transmission member 20 with respect to light at a wavelength of 8 um to 12 um is preferably equal to or higher than 65%. The far-infrared ray transmission member 20 can appropriately transmit far-infrared rays when the average transmittance with respect to light at a wavelength of 8 um to 12 um is equal to or higher than 65%.

The functional film 31 preferably includes one or more visible light absorbing layers 32 containing metal oxide as a principal component. By causing the principal component of the visible light absorbing layer 32 to be metal oxide, the reflectance with respect to visible light and the dispersion D can be appropriately reduced while appropriately transmitting far-infrared rays, and the design of the far-infrared ray transmission member 20 can be appropriately ensured.

The visible light absorbing layer 32 preferably contains at least one material selected from the group consisting of $NiO_x$, $CuO_x$, and $MnO_x$ as the principal component. By forming the visible light absorbing layer 32 with such a material, the reflectance with respect to visible light and the dispersion D can be appropriately reduced while appropriately transmitting far-infrared rays, and the design of the far-infrared ray transmission member 20 can be appropriately ensured.

The functional film 31 preferably includes one or more high refractive index layers 36 the refractive index of which with respect to light at a wavelength of 10 um is higher than that of the visible light absorbing layer 32. By disposing the high refractive index layer 36 in addition to the visible light absorbing layer 32, the functional film 31 can appropriately function as an antireflection film for far-infrared rays.

The functional film 31 preferably includes one or more low refractive index layers 38 the refractive index of which with respect to light at a wavelength of 10 um is lower than that of the visible light absorbing layer 32. By disposing the low refractive index layer 38 in addition to the visible light absorbing layer 32, the functional film 31 can appropriately function as an antireflection film for far-infrared rays.

The functional film 31 includes one or more high refractive index layers 36 the refractive index of which with respect to light at a wavelength of 10 um is higher than that of the visible light absorbing layer 32 and one or more low refractive index layers 38 the refractive index of which with respect to light at a wavelength of 10 um is lower than that of the visible light absorbing layer 32, and the high refractive index layer 36 and the low refractive index layer 38 are preferably alternately laminated between the base material 30 and the visible light absorbing layer 32. In this way, by alternately laminating the high refractive index layer 36 and the low refractive index layer 38 while disposing the visible light absorbing layer 32 on the outer side thereof, the design of the far-infrared ray transmission member 20 can be appropriately ensured while preventing reflection in a wide wavelength range.

The high refractive index layer 36 preferably contains at least one material selected from the group consisting of Si and Ge as a principal component. By using such a material for the high refractive index layer 36, the high refractive index layer 36 can appropriately function as an antireflection film for far-infrared rays.

The low refractive index layer 38 preferably contains MgO as a principal component. By using such material for the low refractive index layer 38, the low refractive index layer 38 can appropriately function as an antireflection film for far-infrared rays.

The base material 30 preferably contains at least one material selected from the group consisting of Si, Ge, ZnS, and chalcogenide glass. By using such a material for the base material 30, far-infrared rays can be appropriately transmitted.

It is preferable that the far-infrared ray transmission member 20 further includes the protective film 34 that is formed on the outer surface and has the refractive index with respect to light at a wavelength of 550 nm equal to or smaller than 2.5. When the far-infrared ray transmission member 20 includes such a protective film, the functional film 31 can be appropriately protected while ensuring the design of the far-infrared ray transmission member 20.

The protective film 34 preferably contains at least one material selected from the group consisting of $ZrO_2$, $Al_2O_3$, $TiO_2$, $Si_3N_4$, AlN, and diamond-like carbon. By using such a material for the protective film 34, the functional film 31 can be appropriately protected while ensuring the design of the far-infrared ray transmission member 20.

The far-infrared ray transmission member 20 is preferably mounted on the vehicle. The far-infrared ray transmission member 20 can ensure the design thereof while appropriately transmitting far-infrared rays, so that the far-infrared ray transmission member 20 can be appropriately mounted on the vehicle.

The far-infrared ray transmission member 20 may be placed on the window member of the vehicle. The far-infrared ray transmission member 20 can ensure the design thereof while appropriately transmitting far-infrared rays, so that the far-infrared ray transmission member 20 can be appropriately mounted on the window member of the vehicle.

The far-infrared ray transmission member 20 may be placed on the exterior member for a pillar of the vehicle. The far-infrared ray transmission member 20 can ensure the design thereof while appropriately transmitting far-infrared rays, so that the far-infrared ray transmission member 20 can be appropriately mounted on the exterior member for a pillar of the vehicle.

The far-infrared ray transmission member 20 may be placed in the light blocking region A2 of the exterior member for the vehicle. The far-infrared ray transmission member 20 can ensure the design thereof while appropriately transmitting far-infrared rays, so that the far-infrared ray transmission member 20 can be appropriately mounted in the light blocking region A2. More specifically, the far-infrared ray transmission member 20 is preferable due to a high affinity for the light blocking region A2 in view of external appearance.

In a method for manufacturing the far-infrared ray transmission member 20 according to the present embodiment, the functional film 31 is formed on the base material 30 that transmits far-infrared rays to manufacture the far-infrared ray transmission member 20 in which the dispersion of the reflectances with respect to the pieces of light at a wavelength of 360 nm to 830 nm in increments of 1 nm is equal to or smaller than 30, the reflectance with respect to visible light defined by JIS R3106 is equal to or lower than 25%, and the average transmittance with respect to light at a wavelength of 8 um to 12 um is equal to or higher than 50%. According to this manufacturing method, it is possible to manufacture the far-infrared ray transmission member 20 that appropriately transmits far-infrared rays while ensuring the design thereof.

In the method for manufacturing the far-infrared ray transmission member 20 according to the present embodiment, the functional film 31 is preferably formed by sputtering. By forming the functional film 31 by sputtering, adhesion of the film can be improved.

(Examples)

The following specifically describes the present invention using examples, but the present invention is not limited thereto. Table 1 to Table 3 indicate the examples. In Table 1 to Table 3, an upper direction side in a space of a film configuration indicates the vehicle exterior side, and a lower direction side indicates the vehicle interior side.

Table 1

| | Example 1 | Example 2 | Example 3 | Example 4 | Example 5 |
|---|---|---|---|---|---|
| Film configuration | Si substrate 2mm | CuOx 1130nm / Si substrate / CuOx 1130nm | NiOx 1140nm / Si substrate / NiOx 1140nm | Black ceramics 10um / Si substrate / NiOx 1140nm | ZrO₂ 1300nm / Si substrate / ZrO₂ 1300nm |
| Visible light absorbing layer | None | CuOx | NiOx | Black ceramics | None |
| Extinction coefficient of visible light absorbing layer (550nm) | - | 0.61 | 0.09 | 0.04 | None |
| Visible light reflectance (%) | 35.9 | 23.1 | 17.0 | 7.5 | 20.8 |
| Evaluation result | × | △ | ○ | ◎ | △ |
| Visible light reflectance dispersion (360nm to 830nm) | 35.7 | 1.1 | 4.0 | 0.6 | 186.3 |
| Evaluation result | × | ◎ | ◎ | ◎ | × |
| Far-infrared light average transmittance (8 to 12μm) (%) | 42.5 | 70.1 | 70.8 | 0 | 63.5 |
| Evaluation result | × | ◎ | ◎ | × | △ |

Table 2

| | Example 6 | Example 7 | Example 8 | Example 9 | Example 10 |
|---|---|---|---|---|---|
| Film configuration | NiOx 1140nm / Ge 1150nm / Si substrate / Ge 1150nm / NiOx 1140nm | NiOx 900nm / MgO 300nm / Ge 1200nm / Si substrate / Ge 1200nm / MgO 300nm / NiOx 900nm | NiOx 900nm / MgO 230nm / Ge 1450nm / MgO 270nm / Ge 340nm / MgO 130nm / Si substrate / Back side is same | ZrO$_2$ 300nm / NiOx 1000nm / Si substrate / NiOx 1000nm / ZrO$_2$ 300nm | Al$_2$O$_3$ 80nm / NiOx 1140nm / Si substrate / NiOx 1140nm / Al$_2$O$_3$ 80nm |
| Visible light absorbing layer | NiOx | NiOx | NiOx | NiOx | NiOx |
| Extinction coefficient of visible light absorbing layer (550nm) | 0.09 | 0.09 | 0.09 | 0.09 | 0.09 |
| Visible light reflectance (%) | 17.9 | 18.4 | 18.5 | 13.0 | 0.7 |
| Evaluation result | ○ | ○ | ○ | ◎ | ◎ |
| Visible light reflectance dispersion (360nm to 830nm) | 6.3 | 17.1 | 18.9 | 9.8 | 9.8 |
| Evaluation result | ○ | △ | △ | ○ | ○ |
| Far-infrared light average transmittance (8 to 12µm) (%) | 73.7 | 74.4 | 74.5 | 68.8 | 68.4 |
| Evaluation result | ◎ | ◎ | ◎ | ○ | ○ |

Table 3

| | Example 11 | Example 12 | Example 13 | Example 14 | Example 15 | Example 16 |
|---|---|---|---|---|---|---|
| Film configuration | NiOx 1140nm / Si 100nm / Si substrate / Si 100nm / NiOx 1140nm | DLC 1um / Si substrate / Ge 100nm / ZnS 1200nm | ZnS 1200nm / Ge 100nm / Si substrate / Ge 100nm / ZnS 1200nm | ZnS substrate 2mm | NiOx 1140nm / Ge 1150nm / ZnS substrate / Ge 1150nm / NiOx 1140nm | NiOx 1200nm / Si substrate 0.525mm / NiOx 1200nm |
| Visible light absorbing layer | NiO$_x$ | DLC | None | None | NiOx | NiOx |
| Extinction coefficient of visible light absorbing layer (550nm) | 0.09 | 0.19 | - | - | 0.09 | 0.02 |
| Visible light reflectance (%) | 17.8 | 16.4 | 28.1 | 27.5 | 17.9 | 15.9 |
| Evaluation result | ○ | ○ | × | × | ○ | ○ |
| Visible light reflectance dispersion (360nm to 830nm) | 4.0 | 0.2 | 223.4 | 2.0 | 6.1 | 43.6 |
| Evaluation result | ◎ | ◎ | × | ◎ | ○ | × |
| Far-infrared light average transmittance (8 to 12μm) (%) | 70.1 | 69.4 | 74.0 | 75.3 | 82.1 | 81.2 |
| Evaluation result | ◎ | ○ | ◎ | ◎ | ◎ | ◎ |

(Example 1)

In an example 1, the base material itself was the far-infrared ray transmission member. That is, in the example 1, only the base material was prepared, and a film was not formed on the base material. In the example 1, Si (FZ grade) was used as the base material. The thickness of the base material was 2 mm $\pm$ 0.1 mm. The thickness was measured by digital calipers (manufactured by Mitutoyo Corporation, CD-15CX).

(Example 2)

In an example 2, the functional films were respectively formed on both surfaces of the base material by magnetron sputtering, and the far-infrared ray transmission member was obtained. In the example 2, Si, which is the same as that in the example 1, was used as the base material, and a $CuO_x$ film as the visible light absorbing layer was used as the functional film. In the example 2, the thickness of the base material was the same as that in the example 1, and the thickness of the functional film was set to be 1.13 $\mu$m.

In the example 2, first, a Cu target as a film forming raw material and the base material were placed to be opposed to each other on a magnetron sputtering device. Next, the entire device was evacuated to be vacuum. At the time when a pressure inside the device reached $5\times10E$-4 Pa, 20 SCCM (standard cc/min, 1 atm (25°C)) of Ar gas and oxygen gas in total were made flow. An evacuation speed was adjusted so that the pressure inside the device became 0.2 Pa at this point. Thereafter, 200 W of DC pulse current (150 kHz) was applied to a target surface, and $CuO_x$ was deposited on the surface of the base material while rotating the base material in front of the target.

Subsequently, the obtained $CuO_x$ film was baked at a temperature of 400°C for one hour in the atmosphere to obtain the far-infrared ray transmission member.

(Example 3)

In an example 3, the functional films were respectively formed on both surfaces of the base material by a magnetron sputtering method, and the far-infrared ray transmission member was obtained. In the example 3, Si, which is the same as that in the example 1, was used as the base material, and an $NiO_x$ film as the visible light absorbing layer was used as the functional film. In the example 3, the thickness of the base material was the same as that in the example 1, and the thickness of the functional film was set to be 1.14 um.

In the example 3, first, an $NiO_x$ target as a film forming raw material and the base material were placed to be opposed to each other on the magnetron sputtering device. Next, the entire device was evacuated to be vacuum. At the time when a pressure inside the device reached $5\times10^{-4}$ Pa, 80 SCCM of Ar gas and oxygen gas in total were made flow. The evacuation speed was adjusted so that the pressure inside the device became 0.5 Pa at this point. Thereafter, 400 W of DC pulse current (20 kHz) was applied to the target surface while heating the substrate at 150°C, and $NiO_x$ was deposited on the surface of the base material.

(Example 4)

In an example 4, a film of black ceramics is formed on a surface on the vehicle exterior side of the base material, and a film of $NiO_x$ is formed on a surface on the vehicle interior side of the base material to obtain the far-infrared ray transmission member. In the example 4, black ceramics were formed by using a black paste (manufactured by Ferro Corporation, Black ink N9-104), and using a screen printing machine. In the example 4, the thickness of the film of black ceramics was set to be 10 um, and the thickness of the film of $NiO_x$ was set to be 1.14 um. In the example 4, except the above description, the far-infrared ray transmission member was manufactured by using the same method as that in the example 3.

(Example 5)

In an example 5, $ZrO_2$ films were formed on both surfaces of the base material by a magnetron sputtering method, and the far-infrared ray transmission member was obtained. In the example 5, the $ZrO_2$ film was formed by sputtering using a Zr target. In the example 5, the thickness of the $ZrO_2$ film was set to be 1.3 um. In the example 5, except the above description, the far-infrared ray transmission member was manufactured by using the same method as that in the example 4.

(Example 6)

In an example 6, the functional films were respectively formed on both surfaces of the base material by a magnetron sputtering method, and the far-infrared ray transmission member was obtained. In the example 6, the functional film was formed by laminating a Ge film as the high refractive index layer and an $NiO_x$ film as the visible light absorbing layer in order from the substrate side. In the example 6, the Ge film was formed by sputtering using a Ge target. In the example 6, the thickness of the film of Ge was set to be 1.15 um, and the thickness of the $NiO_x$ film was set to be 1.14 um. In the example 6, except the above description, the far-infrared ray transmission member was manufactured by using the same method as that in the example 5.

(Example 7)

In an example 7, the functional films were respectively formed on both surfaces of the base material by a magnetron sputtering method, and the far-infrared ray transmission member was obtained. In the example 7, the functional film was formed by laminating a Ge film as the high refractive index layer, an MgO film as the low refractive index layer, and an $NiO_x$ film as the visible light absorbing layer in order from the substrate side. In the example 7, the MgO film was formed by sputtering using an Mg target. In the example 7, the thickness of the film of Ge was set to be 1.2 um, the thickness of the MgO film was set to be 0.3 um, and the thickness of the $NiO_x$ film was set to be 0.9 um. In the example 7, except the above description, the far-infrared ray transmission member was manufactured by using the same method as that in the example 6.

(Example 8)

In an example 8, the functional films were respectively formed on both surfaces of the base material by a magnetron sputtering method, and the far-infrared ray transmission member was obtained. In the example 8, the functional film was formed by alternately laminating five layers including MgO films as the low refractive index layers and Ge films as the high refractive index layers in order from the substrate side, and further laminating an $NiO_x$ film as the visible light absorbing layer thereon. In the example 8, the thickness of the MgO film was set to be 0.13 um, the thickness of the film of Ge was set to be 0.34 um, the thickness of the MgO film was set to be 0.27 um, the thickness of the film of Ge was set to be 1.45 um, the thickness of the MgO film was set to be 0.23 um, and the thickness of the $NiO_x$ film was set to be 0.9 um in order from the substrate side. In the example 8, except the above description, the far-infrared ray transmission member was manufactured by using the same method as that in the example 7.

(Example 9)

In an example 9, the functional film and the protective film were respectively formed on both surfaces of the base material by a magnetron sputtering method, and the far-infrared ray transmission member was obtained. In the example 9, an $NiO_x$ film as the visible light absorbing layer was used as the functional film, and a $ZrO_2$ layer was used as the protective film. In the example 9, the thickness of the film of $NiO_x$ was set to be 1 um, and the thickness of the $ZrO_2$ film was set to be 0.3 um. In the example 9, except the above description, the far-infrared ray transmission member was manufactured by using the same method as that in the example 8.

(Example 10)

In an example 10, the functional film and the protective film were respectively formed on both surfaces of the base material by a magnetron sputtering method, and the far-infrared ray transmission member was obtained. In the example 10, an $NiO_x$ film as the visible light absorbing layer was used as the functional film, and an $Al_2O_3$ layer was used as the protective film. In the example 10, the thickness of the film of $NiO_x$ was set to be 1.14 um, and the thickness of the $Al_2O_3$ film was set to be 0.08 um. In the example 10, except the above description, the far-infrared ray transmission member was manufactured by using the same method as that in the example 9.

(Example 11)

In an example 11, the adhesive film and the functional film were respectively formed on both surfaces of the base material by a magnetron sputtering method, and the far-infrared ray transmission member was obtained. In the example 11, an Si film was used as the adhesive film, and an $NiO_x$ film as the visible light absorbing layer was used as the functional film. In the example 11, the thickness of the film of Si was set to be 0.1 um, and the thickness of the film of $NiO_x$ was set to be 1.14 um. In the example 11, except the above description, the far-infrared ray transmission member was manufactured by using the same method as that in the example 10.

(Example 12)

In an example 12, a film of diamond-like carbon (DLC) was formed as the visible light absorbing layer on the surface on the vehicle exterior side of the base material, a film of Ge as the high refractive index layer and a film of ZnS as the low refractive index layer were laminated in this order as the functional film on the surface on the vehicle interior side of the base material, and the far-infrared ray transmission member was obtained. In the example 12, the thickness of the base material was the same as that in the example 1, the film of diamond-like carbon (DLC) was formed by plasma CVD, and the film of Ge and the film of ZnS were formed by vapor deposition. In the example 12, the thickness of the film of diamond-like carbon was set to be 1 um, the thickness of the film of Ge was set to be 0.1 um, and the thickness of the film of ZnS was set to be 1.2 um. In the example 12, except the above description, the far-infrared ray transmission member was manufactured by using the same method as that in the example 11.

(Example 13)

In an example 13, a film of Ge and a film of ZnS were laminated in this order on both surfaces of the base material, and the far-infrared ray transmission member was obtained. In the example 13, the thickness of the film of Ge was set to be 0.1 um, and the thickness of the film of ZnS was set to be 1.2 um. In the example 13, except the above description, the far-infrared ray transmission member was manufactured by using the same method as that in the example 12.

(Example 14)

In an example 14, the base material itself was the far-infrared ray transmission member. That is, in the example 14, only the base material was prepared, and a film was not formed on the base material. In the example 14, ZnS (MS grade) was used as the base material. The thickness of the base material was 2 mm $\pm$ 0.1 mm.

(Example 15)

In an example 15, the functional films were respectively formed on both surfaces of the base material by a magnetron sputtering method, and the far-infrared ray transmission member was obtained. In the example 15, ZnS, which is the same as that in example 14, was used as the base material, and the functional film was formed by laminating a Ge film as the high refractive index layer and an $NiO_x$ film as the visible light absorbing layer in order from the substrate side. In the example 15, the Ge film was formed by sputtering using a Ge target. In the example 15, the thickness of the film of Ge was set to be 1.15 um, and the thickness of the $NiO_x$ film was set to be 1.14 um. In the example 15, except the above description, the far-infrared ray transmission member was manufactured by using the same method as that in the example 6.

(Example 16)

In an example 16, values of visible light reflectance dispersion and visible light reflectance in a best mode configuration in Non Patent Literature 2 were calculated by using an optical simulation. A P-type Si base material (manufactured by MATSUZAKI SEISAKUSYO CO., LTD.) having a thickness of 0.525 mm disclosed in Non Patent Literature 2 was used as the base material, and $NiO_x$ films, which were obtained by using the method described in Non Patent Literature 2, were placed as functional layers on both surfaces of the base material. The film thickness of $NiO_x$ was set to be 1.2 um, and the values of visible light reflectance and visible light reflectance dispersion were calculated by an optical simulation using an optical constant of the $NiO_x$ film obtained by using the method described in Non Patent Literature 2. The optical simulation was performed by using simulation software (manufactured by HULINKS Inc., TFCalc). A far-infrared average transmittance was taken from Non Patent Literature 2.

(Example 16)

In the example 16, the P-type Si base material (manufactured by MATSUZAKI SEISAKUSYO CO., LTD.) having a thickness of 0.525 mm disclosed in Non Patent Literature 2 was used as the base material, and the $NiO_x$ films, which were obtained by using the method described in Non Patent Literature 2, were placed as the functional layers on both surfaces of the base material. First, an Ni target as a film forming raw material and the base material were placed to be opposed to each other on a magnetron sputtering device. Next, the entire device was evacuated to be vacuum. At the time when a pressure inside the device reached $5 \times 10E-4$ Pa, 20 SCCM (standard cc/min, 1 atm (25°C)) of Ar gas and oxygen gas in total were made flow. The evacuation speed was adjusted so that the pressure inside the device became 3.5 mTorr at this point. Thereafter, 400 W of highfrequency current was applied to a target surface, and $NiO_x$ was deposited on the surface of the base material. Subsequently, annealing was performed on the obtained $NiO_x$ film in the atmosphere at 600°C for one hour to make the far-infrared ray transmission member. The film thickness of $NiO_x$ was set to be 1.2 um.

The example 2, the example 3, the example 6, the example 7, the example 8, the example 9, the example 10, the example 11, the example 12, and the example 15 include the visible light absorbing layer the extinction coefficient of which with respect to light at a wavelength of 550 nm is equal to or larger than 0.04. In the example 16, the extinction coefficient of $NiO_x$ with respect to light at a wavelength of 550 nm is 0.02, which is inappropriate as the visible light absorbing layer. The extinction coefficient with respect to light at a wavelength of 550 nm was determined by performing fitting of an optical model using polarization information obtained by a spectroscopic ellipsometer and a spectral transmittance that is measured based on JIS R3106.

(Evaluation)

For samples in the example 1 to the example 15, performance against visible light and far-infrared ray transmission performance were evaluated. As the performance against visible light, a reflectance of a vehicle outer surface of the sample with respect to visible light, and dispersion of the reflectance with respect to visible light were measured. The reflectance with respect to visible light was measured by using a method defined by JIS R3106. The dispersion corresponding to reflectances with respect to pieces of light at a wavelength of 360 nm to 830 nm in increments of 1 nm measured by using a method defined by JIS R3106 was calculated as the dispersion of the reflectance with respect to visible light. The reflectance with respect to visible light equal to or lower than 15% was indicated by a double circle, the reflectance higher than 15% and equal to or lower than 20% was indicated by a circle, the reflectance higher than 20% and equal to or lower than 25% was indicated by a triangle, the reflectance equal to or lower than 15% was indicated by a cross, and the triangle, the circle, and the double circle were accepted. The dispersion equal to or smaller than 5 was indicated by a double circle, the dispersion larger than 5 and equal to or smaller than 10 was indicated by a circle, the dispersion larger than 10 and equal to or smaller than 30 was indicated by a triangle, the dispersion equal to or larger than 30 was indicated by a cross, and the triangle, the circle, and the double circle were accepted.

In evaluation of the far-infrared ray transmission performance, an average transmittance of the sample was evaluated. Herein, the average transmittance is an average value of the transmittance with respect to light at each wavelength of 8 um to 12 um. In this example, the transmittance of light at each wavelength of 8 um to 12 um was measured by using a Fourier transform type infrared spectroscopic device (manufactured by Thermo Fisher Scientific Inc., product name: Nicolet 1S10), and the average transmittance was calculated from the measured transmittance. In evaluation of the far-infrared ray transmission performance, the average transmittance equal to or higher than 70% was indicated by a double circle, the average transmittance equal to or higher than 65% and lower than 70% was indicated by a circle, the average transmittance equal to or higher than 50% and lower than 65% was indicated by a triangle, the average transmittance lower than 50% was indicated by a cross, and the triangle, the circle, and the double circle were accepted.

(Evaluation of example 16)

In the example 16, values of visible light reflectance dispersion and visible light reflectance in a best mode configuration in Non Patent Literature 2 were calculated by using an optical simulation. Additionally, the values of visible light reflectance and visible light reflectance dispersion were calculated by an optical simulation using an optical constant of the $NiO_x$ film obtained by using the method described in Non Patent Literature 2. The optical simulation was performed by using simulation software (manufactured by HULINKS Inc., TFCalc). The far-infrared average transmittance was taken from Non Patent Literature 2.

(Evaluation results)

Table 1 to Table 3 indicate evaluation results of respective samples. As indicated in Table 1 to Table 3, it can be found that all of the visible light reflectance, the dispersion, and the far-infrared ray average transmittance are satisfied in the example 2, the example 3, the example 6, the example 7, the example 8, the example 9, the example 10, the example 11, the example 12, and the example 15 as the examples. On the other hand, it can be found that at least one of the visible light reflectance, the dispersion, and the far-infrared ray average transmittance is not satisfied in the example 1, the example 4, the example 5, the example 13, and the example 14 as comparative examples.

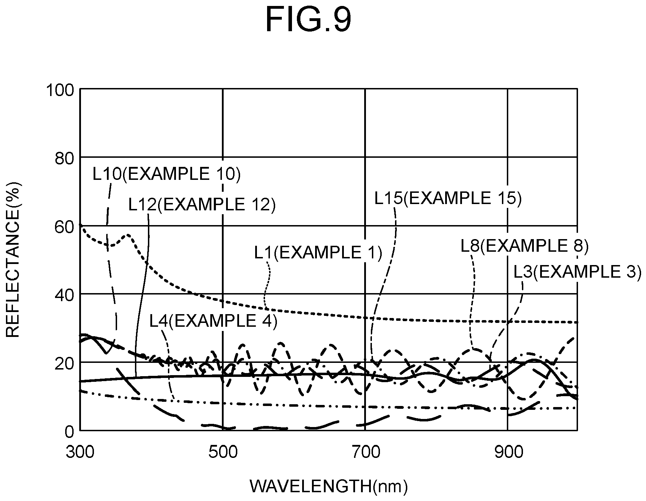

FIG. 8 and FIG. 9 are graphs indicating evaluation results of the respective examples. FIG. 8 is a graph indicating the reflectance for each wavelength in the wavelength range of visible light in the example 5 and the example 13. In FIG. 8, a line segment L5 indicates a result of the example 5, and a line segment L13 indicates a result of the example 13. As illustrated in FIG. 8, it can be found that a difference in (that is, dispersion of) the reflectance for each wavelength is increased in the example 5 and the example 13. When the difference in (that is, dispersion of) the reflectance for each wavelength is increased, an optical interference color of iridescence, which is conspicuous, is generated due to a difference in intensity of reflected light for each wavelength within a surface of an infrared transmission substrate.

FIG. 9 is a graph indicating the reflectance for each wavelength in the wavelength range of visible light in the example 1, the example 3, the example 4, the example 8, the example 10, the example 12, and the example 15. In FIG. 8, a line segment L1 indicates a result of the example 1, a line segment L3 indicates a result of the example 3, a line segment L4 indicates a result of the example 4, a line segment L8 indicates a result of the example 8, a line segment L10 indicates a result of the example 10, a line segment L12 indicates a result of the example 12, and a line segment L15 indicates a result of the example 15. As illustrated in FIG. 9, it can be found that the difference in (that is, dispersion of) the reflectance for each wavelength illustrated in FIG. 9 is reduced in the example 1, the example 3, the example 4, the example 8, the example 12, and the example 15. When the difference in (that is, dispersion of) the reflectance for each wavelength becomes equal to or smaller than 30, an optical interference color of iridescence is not generated within the surface of the infrared transmission substrate, and blackish external appearance having a high affinity for the light blocking region is obtained. Regarding the example 1, the dispersion with respect to visible light is large, and the visible light reflectance is high, that is, equal to or higher than 25%, so that glaring external appearance, which is conspicuous, is obtained. Regarding the example 4, the dispersion with respect to visible light is very small, and the visible light reflectance is sufficiently low, but transmission performance for far-infrared rays is poor. Regarding the example 3, the example 8, the example 12, and the example 15, the dispersion of the reflectance and the visible light reflectance are both sufficiently small, so that blackish inconspicuous external appearance without glaring is obtained.

The embodiment of the present invention has been described above, but the embodiment is not limited thereto. The constituent elements described above include a constituent element that is easily conceivable by those skilled in the art, substantially the same constituent element, and what is called an equivalent. Furthermore, the constituent elements described above can be appropriately combined. In addition, the constituent elements can be variously omitted, replaced, or modified without departing from the gist of the embodiment described above.

Reference Signs List

1 GLASS FOR VEHICLES
10, 12, 14 GLASS BASE BODY
16 INTERMEDIATE LAYER
18 LIGHT BLOCKING LAYER
20 FAR-INFRARED RAY TRANSMISSION MEMBER
30 BASE MATERIAL
31 FUNCTIONAL FILM
32 VISIBLE LIGHT ABSORBING LAYER

**Claims**

1. A far-infrared ray transmission member comprising:

    a base material configured to transmit far-infrared rays; and
    a functional film formed on the base material, wherein
    dispersion of reflectances with respect to pieces of light at a wavelength of 360 nm to 830 nm in increments of 1 nm is equal to or smaller than 30, a reflectance with respect to visible light defined by JIS R3106 is equal to or lower than 25%, and an average transmittance with respect to light at a wavelength of 8 um to 12 um is equal to or higher than 50%.

2. The far-infrared ray transmission member according to claim 1, wherein the average transmittance with respect to light at a wavelength of 8 um to 12 um is equal to or higher than 65%.

3. The far-infrared ray transmission member according to claim 1 or 2, wherein the functional film includes one or more visible light absorbing layer containing metal oxide as a principal component.

4. The far-infrared ray transmission member according to claim 3, wherein the visible light absorbing layer contains

$NiO_x$ as a principal component.

5. The far-infrared ray transmission member according to claim 3, wherein the visible light absorbing layer contains at least one material selected from the group consisting of $CuO_x$ and $MnO_x$ as a principal component.

6. The far-infrared ray transmission member according to claim 4 or 5, wherein an extinction coefficient of the visible light absorbing layer with respect to light at a wavelength of 550 nm is equal to or larger than 0.04.

7. The far-infrared ray transmission member according to any one of claims 3 to 6, wherein the functional film includes one or more high refractive index layers the refractive index of which with respect to light at a wavelength of 10 um is higher than the refractive index of the visible light absorbing layer.

8. The far-infrared ray transmission member according to any one of claims 3 to 7, wherein the functional film includes one or more low refractive index layers the refractive index of which with respect to light at a wavelength of 10 um is lower than the refractive index of the visible light absorbing layer.

9. The far-infrared ray transmission member according to any one of claims 3 to 6, wherein

the functional film includes one or more high refractive index layers the refractive index of which with respect to light at a wavelength of 10 um is higher than the refractive index of the visible light absorbing layer and one or more low refractive index layers the refractive index of which with respect to light at a wavelength of 10 um is lower than the refractive index of the visible light absorbing layer, and
the high refractive index layer and the low refractive index layer are alternately laminated between the base material and the visible light absorbing layer.

10. The far-infrared ray transmission member according to claim 7 or 9, wherein the high refractive index layer contains at least one material selected from the group consisting of Si and Ge as a principal component.

11. The far-infrared ray transmission member according to claim 8 or 9, wherein the low refractive index layer contains MgO as a principal component.

12. The far-infrared ray transmission member according to any one of claims 1 to 11, further comprising:
a protective film that is formed on an outer surface, and has a refractive index with respect to light at a wavelength of 550 nm equal to or smaller than 2.5.

13. The far-infrared ray transmission member according to claim 12, wherein the protective film contains at least one material selected from the group consisting of $ZrO_2$, $Al_2O_3$, $TiO_2$, $Si_3N_4$, AlN, and diamond-like carbon.

14. The far-infrared ray transmission member according to any one of claims 1 to 13, wherein the base material contains at least one material selected from the group consisting of Si, Ge, ZnS, and chalcogenide glass.

15. The far-infrared ray transmission member according to any one of claims 1 to 14, mounted on a vehicle.

16. The far-infrared ray transmission member according to claim 15, placed on a window member of the vehicle.

17. The far-infrared ray transmission member according to claim 15, placed on an exterior member for a pillar of the vehicle.

18. The far-infrared ray transmission member according to claim 15, placed in a light blocking region of an exterior member for the vehicle.

19. A method for manufacturing a far-infrared ray transmission member, the method comprising:
forming a functional film on a base material configured to transmit far-infrared rays to manufacture the far-infrared ray transmission member in which dispersion of reflectances with respect to pieces of light at a wavelength of 360 nm to 830 nm in increments of 1 nm is equal to or smaller than 30, a reflectance with respect to visible light defined by JIS R3106 is equal to or lower than 25%, and an average transmittance with respect to light at a wavelength of 8 um to 12 um is equal to or higher than 50%.

20. The method for manufacturing the far-infrared ray transmission member according to claim 19, wherein the functional film is formed by sputtering.

# FIG.1

# FIG.2

# FIG.3

VEHICLE
EXTERIOR
SIDE

VEHICLE
INTERIOR
SIDE

# FIG.4

# FIG.5

# FIG.6

# FIG.7

# FIG.8

# FIG.9

## INTERNATIONAL SEARCH REPORT

| International application No. |
|---|
| **PCT/JP2021/032470** |

**A.    CLASSIFICATION OF SUBJECT MATTER**

*G02B 1/115*(2015.01)i; *G02B 5/22*(2006.01)i
FI:    G02B1/115; G02B5/22

According to International Patent Classification (IPC) or to both national classification and IPC

**B.    FIELDS SEARCHED**

Minimum documentation searched (classification system followed by classification symbols)

G02B1/115; G02B5/22

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| X | SHIM, Hyun-Bin et al. Nickel-oxide film as an AR coating of Si window for IR sensor packaging. PROCEEDINGS OF SPIE vol. 8704, Infrared Technology and Applications XXXIX., 18 June 2013, 870420, pp. 1-6 | 1-4, 6, 14-20 |
| Y | abstract, page 3, lines 7-12, fig. 3, table 2 | 5, 7-13 |
| X | JP 2006-193067 A (DENSO CORP) 27 July 2006 (2006-07-27) | 1-3, 14-15, 19-20 |
| Y | paragraphs [0022]-[0031], fig. 1-2, 4 | 4-13 |
| X | JP 2017-194489 A (NIPPON ELECTRIC GLASS CO) 26 October 2017 (2017-10-26) | 1-3,15-20 |
| Y | paragraphs [0003]-[0007], [0027], [0049]-[0053], [0071], fig. 2, 7-9 | 4-14 |
| Y | WO 2019/065643 A1 (AGC INC) 04 April 2019 (2019-04-04) paragraphs [0001]-[0006], [0042]-[0044], [0071]-[0072] | 4-6 |
| Y | JP 2004-219995 A (NIPPON ELECTRIC GLASS CO LTD) 05 August 2004 (2004-08-05) paragraphs [0028]-[0029] | 4-6 |

| ✓ Further documents are listed in the continuation of Box C. | ✓ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **29 October 2021** | **16 November 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

| International application No. |
|---|
| **PCT/JP2021/032470** |

**C. DOCUMENTS CONSIDERED TO BE RELEVANT**

| Category* | Citation of document, with indication, where appropriate, of the relevant passages | Relevant to claim No. |
|---|---|---|
| Y | JP 2017-151409 A (TAMRON KK) 31 August 2017 (2017-08-31) <br> paragraphs [0002]-[0009], [0024]-[0029], [0045]-[0051] | 7-11, 14 |
| Y | JP 2001-66424 A (STANLEY ELECTRIC CO LTD) 16 March 2001 (2001-03-16) <br> claims, paragraphs [0008]-[0009], [0025] | 12-13 |
| A | JP 2005-266537 A (STANLEY ELECTRIC CO LTD) 29 September 2005 (2005-09-29) <br> entire text, all drawings | 1-20 |
| A | JP 2015-501001 A (CORNING INCORPORATED) 08 January 2015 (2015-01-08) <br> entire text, all drawings | 1-20 |

Form PCT/ISA/210 (second sheet) (January 2015)

## INTERNATIONAL SEARCH REPORT
### Information on patent family members

International application No.

**PCT/JP2021/032470**

| Patent document cited in search report | | | Publication date (day/month/year) | Patent family member(s) | | | Publication date (day/month/year) |
|---|---|---|---|---|---|---|---|
| JP | 2006-193067 | A | 27 July 2006 | (Family: none) | | | |
| JP | 2017-194489 | A | 26 October 2017 | US | 2019/0107649 | A1 | |
| | | | | paragraphs [0003]-[0007], [0035], [0057]-[0061], [0079], fig. 2, 7-9 | | | |
| | | | | WO | 2017/183432 | A1 | |
| | | | | EP | 3447547 | A1 | |
| | | | | CN | 108496099 | A | |
| WO | 2019/065643 | A1 | 04 April 2019 | CN | 111148725 | A | |
| JP | 2004-219995 | A | 05 August 2004 | (Family: none) | | | |
| JP | 2017-151409 | A | 31 August 2017 | JP | 2017-151408 | A | |
| | | | | CN | 107102383 | A | |
| JP | 2001-66424 | A | 16 March 2001 | (Family: none) | | | |
| JP | 2005-266537 | A | 29 September 2005 | (Family: none) | | | |
| JP | 2015-501001 | A | 08 January 2015 | JP | 2017-95805 | A | |
| | | | | US | 2012/0307353 | A1 | |
| | | | | US | 2017/0175245 | A1 | |
| | | | | WO | 2012/166484 | A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017151408 A

**Non-patent literature cited in the description**

- **HYUN BIN SHIM et al.** Controlling the infrared optical properties of rf-sputtered NiO films for application of infrared window. *Infrared Physics and Technology,* 2015, vol. 72, 135-139

- **HYUN BIN SHIM et al.** Nickel oxide film as an AR coating of Si window for IRsensor packaging. *Infrared Technology and Applications XXXIX, Proc.of SPIE,* vol. 8704, 870420-1